(19) Europäisches Patentamt
European Patent Office
Office européen des brevets

(11) **EP 3 714 198 B1**

(12) **FASCICULE DE BREVET EUROPEEN**

(45) Date de publication et mention de la délivrance du brevet:
**27.10.2021 Bulletin 2021/43**

(21) Numéro de dépôt: **18819326.2**

(22) Date de dépôt: **20.11.2018**

(51) Int Cl.:
*F16P 3/00* *(2006.01)*    *B26D 7/22* *(2006.01)*
*B26D 7/24* *(2006.01)*    *B25F 5/00* *(2006.01)*
*A01G 3/037* *(2006.01)*   *F16P 3/12* *(2006.01)*
*H03K 17/96* *(2006.01)*

(86) Numéro de dépôt international:
**PCT/FR2018/052915**

(87) Numéro de publication internationale:
**WO 2019/102130 (31.05.2019 Gazette 2019/22)**

(54) **DISPOSITIF DE COMMANDE, POUR OUTIL MOTORISÉ ET OUTIL SÉCURISÉ COMPRENANT UN TEL DISPOSITIF DE COMMANDE**

STEUERUNGSVORRICHTUNG FÜR EIN ELEKTROWERKZEUG UND SICHERHEITSWERKZEUG MIT SOLCH EINER STEUERUNGSVORRICHTUNG

CONTROL DEVICE FOR A POWER TOOL AND SAFETY TOOL COMPRISING SUCH A CONTROL DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.11.2017 FR 1771254**
**23.11.2017 FR 1771255**

(43) Date de publication de la demande:
**30.09.2020 Bulletin 2020/40**

(73) Titulaire: **Pellenc**
**84120 Pertuis (FR)**

(72) Inventeurs:
• **PELLENC, Roger**
**84120 Pertius (FR)**
• **LOPEZ, Bernard**
**84240 La Tour D'Aigues (FR)**

(74) Mandataire: **Weber, Etienne Nicolas**
**Cabinet Marek**
**28, rue de la Loge**
**Boîte Postale 42413**
**13201 Marseille Cedex 02 (FR)**

(56) Documents cités:
| | |
|---|---|
| **EP-A1- 2 825 811** | **WO-A1-92/19905** |
| **WO-A1-2006/045988** | **WO-A1-2017/101964** |
| **DE-A1- 2 413 999** | **DE-A1- 19 926 241** |
| **US-A- 4 029 996** | **US-A1- 2010 044 120** |
| **US-B1- 6 590 171** | |

## Description

### Domaine technique

La présente invention concerne un dispositif de commande pour un outil motorisé et un outil sécurisé comprenant un tel dispositif de commande.

On entend par dispositif de commande un dispositif permettant de mettre en fonctionnement ou d'arrêter l'outil ou de modifier le fonctionnement de l'outil en cours d'utilisation. La modification du fonctionnement peut être une modification de façon continue ou discrète d'une vitesse de rotation dans le cas d'un outil présentant un organe actif rotatif. Il peut aussi s'agir, d'une modification de la position relative de tout ou partie d'un organe actif. Dans le cas particulier d'un sécateur électrique, il s'agit, par exemple, de l'ouverture et de la fermeture de la lame de coupe sur le crochet de coupe.

La modification du fonctionnement peut également comporter une modification d'un mode de fonctionnement de l'outil. Par exemple, pour un sécateur, il peut s'agir d'un passage d'un mode de fonctionnement à fermeture proportionnelle de la lame, à un mode de fonctionnement impulsionnel en tout ou rien.

La modification du fonctionnement de l'outil peut également être une modification d'un calibre ou d'une gamme de fonctionnement. Toujours par référence à un sécateur, il s'agit, par exemple, de la commande d'une modification de l'écartement maximum de la lame de coupe par rapport au crochet de coupe ou de la course maximum de la lame.

On considère que l'outil est sécurisé lorsqu'il est pourvu d'un dispositif d'arrêt d'urgence automatique visant à empêcher une blessure d'un utilisateur ou, pour le moins, à limiter la gravité d'une blessure d'un utilisateur en cas de contact inopiné de l'utilisateur avec un organe actif de l'outil.

Le dispositif d'arrêt d'urgence est considéré comme étant automatique si l'arrêt d'urgence est déclenché sans intervention volontaire de l'utilisateur mais à la simple détection d'une situation de risque de blessure.

L'invention trouve des applications pour des machines outil telles que, par exemple, des scies circulaires, ou pour des outils électroportatifs et en particulier pour des outils de coupe présentant une lame mobile ou un organe actif tranchant ou contondant. L'Invention trouve des applications notamment pour des cisailles, des sécateurs, des tronçonneuses, des scies, des meuleuses ou des perceuses.

### Etat de la technique antérieure

Une illustration de l'état de la technique concernant la sécurisation des outils est donnée par les documents suivants :

FR2 712 837
FR2 779 669
FR2 831 476
FR2 838 998
FR2 846 729
FR2 963 081
FR3 001 404
EP2 490 865
EP2 825 811
US5 025 175
US7 365 955
WO2012/025456

Ces documents concernent des machines et des outils à commande électrique pourvus d'un dispositif d'arrêt d'urgence pour éviter qu'un utilisateur ne se blesse. Notamment le document EP 2 825 811 divulgue un dispositif selon le préambule de la revendication 1.

Les outils visés peuvent être notamment des sécateurs électriques tenus à une seule main pour couper de la végétation. Dans ce cas, les utilisateurs tiennent le sécateur électrique à une main et utilisent leur deuxième main, libre, pour la manipulation des végétaux coupés ou à couper. Un risque de blessure existe alors lorsque la main qui ne tient pas le sécateur vient à proximité immédiate ou en contact avec l'organe de coupe lors de la coupe. Dans le cas des sécateurs ou des cisailles, l'organe de coupe, se présente majoritairement sous la forme d'une lame fixe, ou crochet, et d'une lame pivotante. La lame pivotante pivote entre une position ouverte et une position refermée sur le crochet, avec un effet de cisaillement entre la lame pivotante et le crochet. L'organe de coupe de certains sécateurs peut aussi comporter deux lames mobiles coopérant entre elle pour réaliser l'effet de cisaillement lorsque les lames passent d'une position ouverte à une position refermée.

Dans le cas des perceuses, des meuleuses, des scies circulaires ou des tronçonneuses, l'organe de coupe présente des parties tranchantes en rotation autour d'un axe ou en translation.

Dans le cas de machines-outils telles que des cisailles, des broyeurs ou des scies circulaires, des organes de coupe se présentent sous la forme de parties tranchantes en rotation autour d'un axe ou en translation par rapport à un bâti fixe.

Différents moyens sont mis en œuvre pour détecter la proximité immédiate ou le contact de la main avec l'organe de coupe. On peut distinguer notamment des moyens radioélectriques, des moyens à détection de potentiel sur la lame, des moyens capacitifs ou encore des moyens à mesure d'impédance.

Les dispositifs de sécurité connus mettent en œuvre des gants, des chaussures ou encore une balise, reliés électriquement au dispositif de sécurité par un lien de communication. Le lien peut être un lien par fil ou éventuellement par voie hertzienne.

Lorsque des gants sont utilisés, les gants sont pourvus de conducteurs électriques et ont pour fonction de créer un circuit de mesure entre le gant et l'organe de coupe. Similairement, des chaussures conductrices peuvent être utilisées pour créer un circuit de mesure relié à la terre et incluant le corps de l'utilisateur.

L'utilisation de balises électroniques, de gants conducteurs, de chaussures conductrices, ou plus généralement d'un vêtement conducteur reliés électriquement à l'outil de coupe, permet de détecter un contact de l'utilisateur avec l'organe de coupe. Un arrêt d'urgence de l'opération de coupe, en réponse à la détection du contact du vêtement conducteur avec l'organe de coupe, permet d'éviter ou de limiter la gravité d'une blessure éventuelle.

Les dispositifs de sécurité connus présentent cependant un certain nombre de difficultés ou d'inconvénients pour l'utilisateur. Parmi celles-ci on peut relever notamment :

- la gêne occasionnée par un lien filaire entre les vêtements conducteurs et le sécateur,
- un risque de sectionner le lien filaire entre le vêtement conducteur et le sécateur.

**Demandes parentes**

L'invention reprend un certain nombre de caractéristiques des inventions exposées dans les demandes de brevet FR 17/71254 et FR 17/71255 et auxquelles il est fait référence. Elle en constitue un perfectionnement.

**Exposé de l'Invention**

L'invention vise à surmonter les difficultés rencontrées avec les équipements de l'état de la technique.

Elle vise également à proposer le remplacement d'un dispositif de commande existant par un dispositif de commande perfectionné intégrant à la fois des fonctions opératoires, par exemple la commande d'un organe actif, et des fonctions de sécurité.

Un autre but de l'invention est de proposer un dispositif de commande et un outil Intégrant le dispositif de commande qui soit ergonomique, et fiable notamment en ce qui concerne les fonctions de sécurité.

Pour atteindre ces buts l'Invention propose plus précisément un dispositif de commande, pour outil motorisé, comprenant:

- une interface de commande de fonctionnement, pourvue d'un organe de commande à actionnement manuel, présentant une plage d'appui manuel pour un déplacement de l'organe de commande entre une position de repos et au moins une position de fonctionnement,
- une interface impédancemétrique de sécurité comprenant une première électrode de contact manuel et une deuxième électrode de contact manuel, électriquement isolées l'une de l'autre.

Les électrodes de contact manuel sont ménagées sur l'organe de commande et s'étendent sur la plage d'appui manuel de l'organe de commande.

Le dispositif de commande peut être destiné au contrôle d'un outil motorisé et en particulier d'un outil de coupe motorisé.

Une première interface du dispositif de commande est l'interface de commande de fonctionnement c'est-à-dire une interface gouvernant le fonctionnement de l'outil. L'interface de commande de fonctionnement peut être une interface électrique dans le sens où elle émet un signal électrique, modifie un signal électrique ou modifie une propriété électrique d'un circuit de commande, par exemple une résistance, une capacité, une inductance, ou une fréquence d'un signal d'un circuit de commande. Dans une expression très simple de l'interface de commande de fonctionnement, celle-ci peut se résumer à un interrupteur pouvant servir de mise sous tension ou de coupure d'un circuit d'alimentation électrique d'un moteur électrique. Elle peut aussi comporter un gradateur, une résistance variable ou un condensateur variable permettant de générer un signal variable en fonction d'un déplacement ou d'une position de l'organe de commande à actionnement manuel. L'interface de commande peut encore comporter un capteur optique, par exemple un capteur de distance, mesurant une position de l'organe de commande et délivrant un signal fonction de cette position.

L'organe de commande fait partie de l'interface de commande de fonctionnement. Il permet à un utilisateur de saisir les commandes essentiellement en appuyant sur l'organe de commande ou en modifiant la position de l'organe de commande. L'organe de commande peut se présenter sous la forme d'un bouton poussoir, sous la forme d'une gâchette à levier ou sous la forme d'une détente, par exemple.

Bien que l'interface de commande de fonctionnement soit de préférence une interface électrique il peut également s'agir d'une interface mécanique agissant, par exemple, sur l'admission d'un moteur d'entrainement thermique.

Le déplacement de l'organe de commande s'entend essentiellement entre une position de repos, correspondant à l'arrêt de l'outil et au moins une position de fonctionnement, correspondant par exemple au travail de l'outil. Le travail de l'outil est essentiellement compris comme une mise en mouvement d'un organe actif de l'outil. Cet aspect est décrit plus loin. Plus précisément, l'organe de commande peut se trouver dans une position d'arrêt, ou de repos, dans lequel aucune commande n'est transmise et dans lequel un outil équipé du dispositif de commande est à l'arrêt ou en veille. L'organe de commande peut également se trouver dans une ou plusieurs positions de fonctionnement correspondant à un ou plusieurs états ou modes de fonctionnement de l'outil ou à un fonctionnement proportionnel de l'outil, dans le cas d'une commande proportionnelle à l'amplitude de déplacement de l'organe de commande. A titre d'exemples, une commande proportionnelle peut gouverner une vitesse de rotation variable dans le cas d'une perceuse ou d'une défonceuse. Une commande proportionnelle peut aussi gouverner une position relative d'une lame de coupe d'un sécateur par rapport à un crochet de sécateur.

On considère que l'organe de commande est manuel lorsqu'il est destiné à être actionné par la main, avec un seul doigt, une pluralité de doigts, ou éventuellement avec une autre partie de la main comme la paume. La main peut être nue ou habillée totalement ou partiellement d'un gant conducteur électrique, en particulier au niveau de son contact avec l'organe de commande.

La mention de la main de l'utilisateur dans la suite de la description ne préjuge pas du fait que la main soit nue ou revêtue d'un gant conducteur et ne préjuge pas de la partie de la main ou du doigt exerçant la commande.

La plage d'appui manuel de l'organe de commande désigne la ou les parties de l'organe de commande entrant en contact avec la main de l'utilisateur lorsque l'utilisateur actionne l'organe de commande. L'actionnement a lieu, par exemple en exerçant une pression sur la plage d'appui de l'organe de commande.

Une deuxième interface du dispositif de commande, distincte de l'interface de commande de fonctionnement, est l'interface impédancemétrique. On entend par interface impédancemétrique une interface permettant de mesurer ou comparer une ou plusieurs impédances, et, par extension, une ou plusieurs caractéristiques électriques fonction d'une impédance. Il s'agit, par exemple, d'une impédance ohmique et/ou d'une tension et/ou d'un courant variant proportionnellement à une Impédance. En particulier la première et la deuxième électrode de l'interface impédancemétrique peuvent faire partie d'un même circuit électrique ou de deux circuits électriques distincts pour l'établissement de caractéristiques électriques à comparer. Une description plus détaillée de possibilités d'utilisation de l'interface impédancemétrique est donnée plus loin.

De manière avantageuse, comme les électrodes de contact manuel de l'interface impédancemétrique s'étendent sur la plage d'appui de l'organe de commande il est possible de détecter la présence de la main d'un utilisateur en contact avec l'interface impédancemétrique, simultanément avec les deux électrodes de contact manuel, au moment où l'utilisateur actionne l'organe de commande en appuyant sur cet organe.

Accessoirement l'interface impédancemétrique peut comporter ou peut être associée à au moins un gant conducteur électrique porté par un utilisateur du dispositif de commande. On entend par gant conducteur électrique un gant conducteur dans son ensemble ou un gant comportant une partie conductrice électrique associé à une partie de la main de l'utilisateur au contact de l'organe de commande. Il s'agit par exemple d'un doigtier conducteur électrique pour un organe de commande associé à un doigt de la main. Le caractère conducteur du gant s'entend de la partie extérieure du gant susceptible de venir toucher l'interface impédancemétrique pour abaisser l'impédance du contact avec les électrodes de contact manuel de l'interface impédancemétrique. Il s'entend également de la partie intérieure du gant venant en contact de la main de l'utilisateur. Dans ce cas, la partie intérieure conductrice et la partie extérieure conductrice sont électriquement reliées entre elles pour établir un contact entre la main de l'utilisateur et les électrodes de contact manuel. De préférence, et pour établir un bon niveau de contact d'impédance faible entre la main et le gant, une grande surface de contact est privilégiée et la partie intérieure du gant peut être entièrement conductrice. Le gant conducteur peut comporter des fibres conductrices en métal (argent, acier inoxydable, nickel, ...) ou à base de fibres de carbone, par exemple.

Par retour à l'organe de commande, et selon une possibilité de réalisation avantageuse de cet organe, celui-ci peut présenter au moins l'un parmi un premier relief en creux, et un séparateur isolant électrique comprenant un matériau choisi parmi un matériau absorbant l'humidité et un matériau hydrophobe, le premier relief en creux, respectivement le séparateur, s'étendant sur la plage d'appui manuel, entre la première électrode de contact manuel et la deuxième électrode de contact manuel.

La fonction du premier relief en creux, ou du séparateur, est d'éviter la formation d'un pont conducteur entre la première et la deuxième électrode en raison d'une humidité susceptible de s'accumuler sur l'organe de commande et fausser ainsi la détection du contact de l'utilisateur sur l'interface impédancemétrique. L'humidité susceptible de s'accumuler sur l'organe de commande peut provenir à la fois du milieu environnant ou de la transpiration de l'utilisateur. A titre d'exemple, lorsque le dispositif de commande fait partie d'un sécateur, une humidité de l'organe de commande peut résulter de l'utilisation du sécateur dans une vigne ou un verger en sève, pendant ou après une pluie, ou sur des plantes couvertes de rosée.

Dans le cas d'un fin film humide sur l'organe de commande, le ou les reliefs en creux peut constituer une barrière de rupture du film. Dans le cas d'une humidité plus importante, le ou les reliefs en creux peuvent en outre servir à piéger l'humidité par capillarité ou de constituer un canal ou un drain d'évacuation de l'humidité.

Pour améliorer encore la barrière de rupture de film procurée par le premier relief en creux, celui-ci peut être un relief à bords angulaires.

L'organe de commande peut aussi comporter un séparateur capable d'absorber puis drainer l'humidité, ou au contraire capable de repousser l'humidité. Il permet d'éviter un film d'humidité et donc un contact intempestif de faible impédance entre les deux électrodes de contact manuel en l'absence de contact manuel. Le séparateur peut être prévu en lieu et place du relief en creux, ou en plus du relief en creux tout en présentant les mêmes effets.

Le séparateur peut être réalisé en un matériau absorbant l'humidité, par exemple, une céramique poreuse. Le séparateur peut également être réalisé en un matériau hydrophobe tel que le PVDF (polyfluorure de vinylidène), le PTFE (polytétrafluoréthylène), le Téflon (polytétrafluoréthylène), ou une mousse à cellules fermées en matériaux hydrophobe. Il peut être massif ou se présenter sous la forme d'un revêtement de surface. Le séparateur peut encore être utilisé pour constituer une entretoise entre les électrodes de contact manuel ou un support des électrodes de contact manuel.

Selon une configuration préférée, dans laquelle l'organe de commande présente une forme allongée, la première et la deuxième électrode de contact manuel, et ledit premier relief en creux peuvent s'étendre longitudinalement sur l'organe de commande.

L'organe de commande peut être exécuté de différentes manières, il peut comporter, par exemple, l'un parmi une gâchette à levier et un bouton poussoir.

Selon le cas, l'actionnement de l'organe de commande peut se faire en appuyant sur l'organe de commande de manière à l'enfoncer en direction de sa base ou de manière à le faire pivoter, dans le cas d'un levier pivotant.

Selon une possibilité de réalisation particulière de l'organe de commande dans lequel l'organe de commande est un levier, le premier relief en creux peut s'étendre sur une première face du levier formant la plage d'appui manuel. Le levier peut comporter au moins un deuxième relief en creux s'étendant sur une deuxième face du levier opposée à la première face du levier.

Le premier relief en creux et le deuxième relief en creux peuvent être simples ou dédoublés ou sous la forme de plusieurs reliefs adjacents, par exemple.

Selon une autre possibilité de réalisation de l'organe de commande, dans lequel l'organe de commande est un levier, le premier relief en creux peut comporter un évidement traversant le levier entre une première face du levier et une deuxième face du levier, opposée à la première face du levier. L'évidement traversant peut permettre ainsi à l'humidité de s'écouler vers une face du levier ne comprenant pas les électrodes, par exemple. L'évidement peut permettre aussi de détecter la présence de la main de l'utilisateur au niveau de l'organe de commande par l'intermédiaire d'un éventuel capteur optique disposé en regard de la deuxième face.

La première face du levier et la deuxième face du levier peuvent être, par exemple, des faces parallèles à l'axe du pivot du levier. L'une des faces peut constituer ou faire partie de la plage d'appui de l'organe de commande, recevant ainsi le doigt ou la main de l'utilisateur pour actionner le levier.

L'organe de commande, que ce soit un bouton poussoir ou un levier, peut comporter un corps central en un matériau isolant électrique et des garnitures en un matériau conducteur électrique rapportées sur des flancs latéraux du corps central, les garnitures formant respectivement la première électrode de contact manuel et la deuxième électrode de contact manuel.

Les flancs latéraux du corps central sont considérés comme des flancs parallèles à un plan de déplacement de l'organe de commande entre la position de repos et la position de fonctionnement. Le corps central sert à isoler électriquement, entre elles, les garnitures métalliques et donc les électrodes de contact manuel. Le corps central peut également servir de support pour les garnitures métalliques.

L'organe de commande peut être chargé par un ressort de rappel ramenant l'organe de commande depuis une position de fonctionnement vers la position d'arrêt lorsque l'utilisateur relâche la pression exercée sur la plage d'appui.

L'invention concerne également un outil motorisé sécurisé comprenant:

- un organe actif conducteur électrique,
- un dispositif de commande électriquement isolé de l'organe actif,
- un moteur d'entrainement de l'organe actif
- un dispositif de surveillance à comparateur de caractéristiques électriques, sensible à un contact d'un utilisateur avec l'organe actif,
- un dispositif d'arrêt d'urgence de l'organe actif, piloté par le dispositif de surveillance.

Conformément à l'invention :

- le dispositif de commande est conforme à celui décrit précédemment,
- le moteur d'entrainement de l'organe actif est commandé par l'intermédiaire de l'interface de commande de fonctionnement du dispositif de commande et
- le dispositif de surveillance comprend l'interface impédancemétrique de sécurité du dispositif de commande.

L'outil peut être une machine-outil ou un outil portatif. Il peut s'agir d'un outil à moteur thermique ou, de préférence, d'un outil à moteur électrique. Le dispositif d'arrêt d'urgence peut comporter différents organes dont les fonctions sont d'interrompre l'alimentation en énergie du moteur d'entrainement, et/ou de freiner le moteur d'entrainement, et/ou de freiner l'organe actif, et/ou d'entraver l'organe actif. L'arrêt d'urgence peut également consister à déclencher un mouvement d'urgence antagoniste permettant de contrer un mouvement normal de l'organe actif et de compenser l'énergie cinétique d'éventuels composants en mouvement. Les composants en mouvement peuvent être ceux de l'organe actif, du moteur d'entrainement de l'organe actif ou d'une transmission reliant le moteur à l'organe actif.

En particulier lorsque le moteur d'entrainement est un moteur électrique, une carte électronique de commande du moteur peut être prévue pour commander des fonctions de freinage électromagnétique utilisant le moteur électrique. Un frein électromagnétique peut également agir sur un volant du moteur ou encore directement sur l'organe actif.

Tout ou partie de l'organe actif est en un matériau conducteur électrique. Ceci ne préjuge toutefois pas de la présence ou non d'un éventuel revêtement isolant à sa surface. L'organe actif est susceptible d'intervenir, comme cela est décrit plus loin, dans la surveillance de l'utilisation de l'outil à travers un contact ohmique, ou capacitif de l'utilisateur avec l'organe actif.

L'organe actif peut être en particulier un organe de coupe. Il peut comporter une lame de coupe d'une cisaille ou d'un sécateur. L'organe actif peut aussi comporter le mandrin d'une perceuse ou d'une défonceuse, équipés d'un foret ou d'une fraise, le cas échéant.

Le dispositif de commande de l'invention a une double fonction. Une première fonction est une fonction d'interface permettant à un utilisateur de saisir des commandes de fonctionnement de l'outil. Il peut s'agir de commandes en tout ou rien, telles que la mise en fonctionnement de l'outil, l'enclenchement d'un mode de fonctionnement particulier de l'outil ou le retour de l'outil à l'arrêt ou dans un mode de veille. Les commandes peuvent également être des commandes proportionnelles gouvernant, par exemple une vitesse de rotation du moteur d'entrainement et/ou de l'organe actif, ou des commandes de déplacement proportionnel de tout ou partie de l'organe actif.

Le dispositif de commande a également une fonction de surveillance à travers le dispositif de surveillance de l'outil qui comprend l'interface impédancemétrique du dispositif de commande.

Plusieurs possibilités de configuration du dispositif de surveillance et d'utilisation de l'interface impédancemétrique sont décrites ci-après.

Selon une première possibilité, le dispositif de surveillance peut comporter:

- un premier circuit électrique comprenant la première électrode de contact manuel, une première impédance électrique et l'organe actif, le premier circuit électrique étant susceptible d'être fermé, lors d'un contact simultané de l'utilisateur avec ladite première électrode de contact manuel et l'organe actif,
- un deuxième circuit électrique comprenant la première et la deuxième électrode de contact manuel, la première impédance électrique et une deuxième impédance électrique, le deuxième circuit électrique étant susceptible d'être fermé lors d'un contact simultané de l'utilisateur avec la première et la deuxième électrode de contact manuel,

- au moins un dispositif de mesure d'une caractéristique d'impédance du premier circuit électrique et d'une caractéristique d'impédance du deuxième circuit électrique,
- un comparateur de la caractéristique d'impédance du premier circuit électrique et d'au moins une caractéristique de seuil fonction de la caractéristique d'impédance du deuxième circuit électrique, le comparateur étant relié au dispositif d'arrêt d'urgence, pour provoquer un arrêt d'urgence en cas de franchissement de la caractéristique de seuil.

Les termes "première impédance" ou "deuxième impédance désignent respectivement un ou plusieurs composants électroniques pouvant comporter une composante résistive mais également une composante capacitive et/ou inductive. Dans une réalisation préférée la première impédance et la deuxième impédance peuvent être formées chacune par un composant électronique tel qu'une résistance électrique de valeur définie. La première impédance et la deuxième impédance présentent des valeurs ohmiques fixes et connues.

Par ailleurs et concernant le premier et le deuxième circuit électrique, on entend par "caractéristique d'impédance" une valeur de tension, de courant, une valeur ohmique, ou plus généralement une caractéristique électrique liée respectivement à l'impédance du premier circuit électrique et du deuxième circuit électrique. La caractéristique d'impédance est établie par le dispositif de mesure. La caractéristique de seuil peut également être une valeur de tension, de courant ou une valeur ohmique fonction de la caractéristique d'impédance du deuxième circuit. Elle peut notamment être proportionnelle à la caractéristique d'impédance du deuxième circuit électrique ou égale à cette caractéristique d'impédance.

Le contact simultané de la main de l'utilisateur avec la première et la deuxième électrode de contact manuel de l'interface impédancemétrique permet de relier électriquement ces électrodes par l'intermédiaire de la main de l'utilisateur, avec une impédance correspondant essentiellement à la somme des impédances de contact entre la main et chacune de la première électrode et de la deuxième électrode de contact manuel.

Pour garantir un bon contact physique et électrique la main de l'utilisateur utilisée pour actionner le dispositif de commande peut être vêtue d'un gant électriquement conducteur, au moins au niveau des surfaces du gant en regard avec la plage d'appui manuel, réduisant les impédances de contact. La description qui suit ne préjuge pas de l'utilisation ou non d'un gant conducteur, et, comme indiqué précédemment, ne préjuge pas de la partie de la main entrant en contact avec les électrodes.

La main de l'utilisateur présente une partie différente en contact avec chacune des électrodes de contact manuel de l'interface impédancemétrique et ainsi une impédance de contact qui peut être différente avec chaque électrode de contact manuel. Chacune de ces impédances dépend aussi de l'état de la main de l'utilisateur, de sa pression sur les électrodes, de l'état de surface des électrodes, des conditions ambiantes et bien entendu du port éventuel de gants conducteurs.

En négligeant l'impédance propre des électrodes de contact manuel de l'interface Impédancemétrique et du câblage du dispositif de surveillance, les impédances de contact de la main avec chacune des électrodes de contact manuel de l'interface impédancemétrique se trouvent en série avec la première impédance électrique et la deuxième impédance électrique dans le deuxième circuit électrique. Les valeurs de la première et de la deuxième impédance électrique sont connues et fixées lors de la fabrication de l'outil.

Le dispositif de mesure d'une caractéristique d'impédance du deuxième circuit en donne une valeur caractérisant la somme de ces impédances.

Le premier circuit électrique, qui comprend la première électrode de contact manuel, la première impédance électrique et l'organe actif conducteur reste un circuit ouvert lorsque l'utilisateur touche l'interface impédancemétrique. Or, lorsqu'il est ouvert, l'impédance totale du premier circuit électrique est quasi infinie, donc forcément supérieure à l'impédance du deuxième circuit électrique.

Le premier circuit électrique est en revanche fermé lorsque l'utilisateur touche simultanément l'organe actif conducteur électrique et la première électrode de contact manuel. Dans la suite de la description, on considère, par simplification, que l'utilisateur touche l'organe actif de l'outil avec un doigt de la main qui ne touche pas l'interface impédancemétrique. L'évocation du doigt qui touche l'organe actif ne préjuge cependant pas de la partie du corps susceptible de toucher l'organe actif. Le fonctionnement du dispositif de sécurité de l'invention est en effet identique lors d'un contact d'une autre partie du corps de l'utilisateur, tel que le visage, l'avant-bras, la jambe ou la main libre, avec l'organe actif.

Lorsque le premier circuit électrique est fermé par un contact inopiné du doigt avec l'organe actif, associé au contact de la main avec la première électrode de contact manuel de l'interface impédancemétrique, la première impédance, l'impédance de contact de la main avec la première électrode de contact manuel, l'impédance du corps de l'utilisateur entre sa main en contact avec la première électrode de contact manuel et le doigt touchant l'organe actif, l'impédance de contact du doigt avec l'organe actif, et l'organe actif se trouvent reliés en série dans le premier circuit électrique.

Ainsi le dispositif de mesure d'une caractéristique d'impédance du premier circuit électrique donne une valeur de la somme de ces impédances.

On estime que l'Impédance des électrodes, du câblage et celle de l'organe actif sont négligeables. L'ordre de grandeur de l'impédance du corps de l'utilisateur, entre sa première main amenée à toucher l'interface impédancemétrique et l'autre main amenée à toucher l'organe actif, est par ailleurs connue. Elle est en effet liée à la conductivité du corps humain et présente une valeur inférieure à dix mille Ohms. En revanche, l'impédance de contact de la main avec la ou les électrodes de contact manuel, dans le premier et dans le deuxième circuit électrique ainsi que la valeur de l'impédance de contact entre le doigt et l'organe actif peuvent présenter une grande variabilité et sont le plus souvent très supérieures à la valeur de l'impédance du corps de l'utilisateur, notamment en cas de pression de contact faible et d'une peau de la main ayant une faible conductivité. Or, quand le contact du doigt avec l'organe actif est proche d'un risque de blessure, la valeur de l'impédance de contact du doigt avec l'organe actif devient du même ordre de grandeur voire inférieure à la valeur de l'impédance du corps de l'utilisateur.

Dans le cas particulier ou l'organe actif est une lame de coupe, le doigt présente une élasticité importante lorsque la lame vient à son contact et ce n'est qu'avec une pression significative que la lame peut d'abord couper l'épiderme du doigt provoquant une blessure légère avant d'effectuer une blessure grave en poursuivant la coupe. Dans ce dernier cas, de coupure légère, comme une griffure au niveau de l'épiderme, la valeur de l'impédance de contact entre l'organe actif, en l'occurrence la lame de coupe et les parties sous-cutanées du corps est alors très inférieure à la valeur de l'impédance du corps humain.

On en déduit donc que la valeur de l'impédance de contact au niveau de l'organe actif en cas de contact sérieux est inférieure à la valeur de l'impédance du corps humain. Une détection d'une impédance de cet ordre de grandeur permet alors d'identifier avec une très grande probabilité l'existence d'un contact instantané et non souhaité de l'utilisateur avec l'organe actif.

Il n'en est pas de même de l'impédance de contact de la main de l'utilisateur touchant l'interface impédancemétrique. Cette impédance de contact peut varier dans des proportions plus importantes. De fait, la simple mesure de la caractéristique d'impédance du premier circuit ne permet pas à elle seule d'identifier l'existence d'un contact entre l'utilisateur et l'organe actif.

Dès qu'il y a une blessure légère avec l'organe actif, l'impédance de contact chute très rapidement à une valeur inférieure à l'impédance du corps humain et elle chute encore lorsqu'il y a une coupure ou une blessure profonde pour atteindre une valeur très faible de quelques centaines d'Ohms. L'impédance de seuil caractéristique d'un tel contact, compte tenu de sa valeur globalement faible et en tous cas estimée à un ordre de grandeur inférieur à l'impédance du corps humain, est largement masquée par les variations possibles de l'impédance de contact entre la main de l'utilisateur et la première électrode de contact manuel de l'interface impédancemétrique. On ne peut donc ainsi caractériser de façon suffisamment fiable l'existence d'un risque de contact au niveau de l'organe actif par une simple mesure de la caractéristique d'impédance du premier circuit.

La fixation d'une valeur seuil permettant d'établir la certitude d'un contact entre le doigt de l'utilisateur et l'organe actif et permettant de s'affranchir des variations de la caractéristique de contact entre la main de l'utilisateur et l'interface impédancemétrique est donc importante.

Ceci a lieu, conformément à l'invention, en fixant une caractéristique de seuil à partir de la caractéristique d'impédance du deuxième circuit. Il est ainsi possible de confronter l'impédance du premier circuit électrique à celle de la deuxième impédance, en s'affranchissant de l'influence de l'impédance de contact de la main avec les électrodes de contact manuel de l'interface impédancemétrique et notamment l'impédance de contact de la main avec la première électrode de contact manuel. En cas de passage d'une valeur d'impédance élevée du premier circuit électrique vers une valeur plus faible que le seuil déterminé à partir de la mesure effectuée sur le deuxième circuit électrique, on détermine alors l'existence d'un risque très élevé de contact entre l'utilisateur et l'organe actif. Le dispositif d'arrêt d'urgence est alors actionné.

Ainsi, et comme mentionné précédemment, la caractéristique de seuil est fixée en fonction de la caractéristique d'Impédance du deuxième circuit électrique qui sert de circuit de référence.

L'impédance du deuxième circuit électrique est égale à la somme de la première impédance, de la deuxième impédance et des impédances de contact de la main sur les électrodes de contact manuel. La somme de la première impédance et deuxième impédance est de préférence fixée à une valeur supérieure à la somme d'une impédance estimée du corps de l'utilisateur et d'une impédance estimée de contact du doigt sur l'organe actif sans blessure grave. Par exemple, en exprimant les impédances et les caractéristiques d'impédance en ohms ($\Omega$), la valeur cumulée de la première et de la deuxième impédance peut être choisie supérieure à 20kQ, et de préférence supérieure à 100k$\Omega$. L'impédance du corps et l'impédance de contact du doigt étant estimées inférieures à 10k$\Omega$ chacune. Celle-ci est d'autant plus faible que la main de l'utilisateur touchant l'interface impédancemétrique est vêtue d'un gant conducteur. Dans un tel cas, et en l'absence de contact du doigt avec l'organe actif, l'Impédance du premier circuit est quasi-infinie et nettement supérieure à 20k$\Omega$ ou 100k$\Omega$. Le choix d'une impédance plus élevée que celle résultant d'une blessure permet de sécuriser encore davantage le dispositif et d'éviter une blessure, y compris une blessure légère.

Lorsque le doigt arrive en contact avec l'organe actif, l'impédance du corps de l'utilisateur et du contact de son doigt sur l'organe actif, dans le premier circuit électrique devient alors inférieure à la valeur d'impédance de la somme de la première et de la deuxième impédance électrique du deuxième circuit électrique. Ainsi la caractéristique d'impédance mesurée du premier circuit électrique devient inférieure à la caractéristique d'impédance de seuil ou, pour le moins franchit la caractéristique de seuil. On rappelle que les caractéristiques d'impédance mesurées peuvent être exprimées sous la forme d'une tension, d'un courant ou d'une valeur ohmique. Selon le cas, la valeur de seuil est franchie lorsque la caractéristique d'impédance du premier circuit passe d'une valeur supérieure à la caractéristique de seuil à une valeur inférieure à la caractéristique de seuil (cas de la tension ou de l'impédance) ou en passant d'une valeur Inférieure à la caractéristique de seuil à une valeur supérieure à la caractéristique de seuil (cas du courant).

Il convient de noter que les valeurs de la première impédance et de la deuxième impédance électrique ne sont pas nécessairement supérieures à une valeur estimée de la somme de l'impédance du corps de l'utilisateur et de l'impédance de contact du doigt. En effet en choisissant une caractéristique de seuil en fonction de la caractéristique d'impédance du deuxième circuit, et en particulier proportionnellement à cette caractéristique d'impédance il est possible d'ajuster la caractéristique de seuil avec un coefficient de proportionnalité de manière à optimiser la mise en sécurité de l'outil.

Selon des modes de réalisation préférés, une ou plusieurs des caractéristiques suivantes peuvent également être retenues :

- la deuxième impédance électrique présente une valeur ohmique supérieure à 20k$\Omega$, et de préférence supérieure à 100k$\Omega$.

- la première impédance électrique présente une valeur ohmique égale à celle de la deuxième impédance électrique.

- la première impédance électrique et la deuxième impédance électriques sont purement résistives.

En particulier, la première impédance électrique peut présenter une valeur ohmique égale à celle de la deuxième impédance électrique et supérieure à une valeur de 20k$\Omega$, et la première caractéristique de seuil peut être choisie égale à la caractéristique d'impédance du deuxième circuit.

La mesure de la caractéristique d'impédance du premier circuit électrique et la mesure de la caractéristique d'impédance du deuxième circuit électrique ne sont pas nécessairement concomitantes mais peuvent être alternées en fonction des déclenchements de l'organe actif, et en particulier des déclenchements de coupe d'un sécateur. Le fait d'alterner les mesures permet notamment d'utiliser un unique dispositif de mesure pour mesurer les caractéristiques d'impédance des deux circuits.

Dans ce cas, le deuxième circuit électrique peut comporter un interrupteur, l'interrupteur étant piloté par l'interface de commande de fonctionnement pour ouvrir le deuxième circuit lors d'un déclenchement de fonctionnement, et pour fermer le deuxième circuit en l'absence de déclenchement de fonctionnement, le dispositif de mesure étant configuré pour mesurer une caractéristique d'impédance du premier circuit électrique lorsque le deuxième circuit est ouvert et pour mesurer une caractéristique d'impédance du deuxième circuit électrique lorsque le deuxième circuit est fermé.

Le terme "interrupteur" est compris ici de manière fonctionnelle. Il peut s'agir d'un interrupteur électromécanique ou d'un interrupteur à transistor passant d'un état conducteur à un état bloqué et inversement.

L'interrupteur est considéré comme piloté par l'interface de commande de fonctionnement lorsque son ouverture est mécaniquement ou électriquement asservie à l'actionnement de l'organe de commande.

La commande de fonctionnement dont il est question ici peut notamment être une commande de coupe lorsque l'organe actif est un organe de coupe.

Dans le cas d'une mesure alternative de la caractéristique d'impédance du premier circuit électrique et de la caractéristique d'impédance du deuxième circuit électrique, la valeur de seuil, qui est fonction de la caractéristique d'impédance du deuxième circuit électrique peut être modifiée et mise à jour à intervalles de temps réguliers et/ou à chaque nouvelle mesure de cette caractéristique d'impédance.

Aussi l'outil peut comporter une mémoire de conservation de la caractéristique de seuil. La mémoire peut être rafraichie à chaque nouvelle mesure, et la valeur conservée est fournie au comparateur.

Comme évoqué précédemment, le dispositif de mesure ne mesure pas nécessairement une impédance du premier et du deuxième circuit, mais pour le moins une caractéristique d'impédance, c'est-à-dire une caractéristique liée à l'Impédance. En particulier, le dispositif de mesure peut comporter une source de courant électrique en série avec le premier et le deuxième circuit électrique et au moins l'un parmi :

- un voltmètre connecté en parallèle aux bornes de la première impédance,
- un ampèremètre ou un ohm-mètre connecté en série avec la première impédance.

Dans ce cas, la tension relevée par le voltmètre ou l'intensité du courant relevée par l'ampèremètre ou l'impédance relevée par l'Ohm-mètre sont utilisables comme des caractéristiques d'impédance.

La caractéristique de seuil peut être fixée de manière comparable comme étant une tension, une impédance ou un courant de seuil.

La fermeture du premier circuit électrique par un contact du doigt sur l'organe actif provoque, le cas échéant, une augmentation du courant traversant le premier circuit, une diminution de la tension aux bornes de la première impédance ou une diminution de la caractéristique d'impédance, et donc un franchissement de la caractéristique de seuil.

Selon un mode de réalisation perfectionné, la source de courant électrique du dispositif de mesure peut être une source de courant alternatif. Il s'agit, par exemple, d'une source avec une fréquence alternative de 10 kHz. L'utilisation d'une source de courant alternatif permet d'envisager la mise en œuvre de l'invention avec un outil dont l'organe actif, conducteur, serait recouvert d'un revêtement isolant, notamment pour éviter sa corrosion. Ceci peut être le cas, par exemple, lorsque la lame d'un sécateur est recouverte d'un fin revêtement en PTFE de façon à faciliter son glissement sur la contre-lame lors de la coupe. Le contact du doigt avec l'organe actif serait dans ce cas un contact majoritairement capacitif.

La description qui suit concerne une autre possibilité de configuration du dispositif de surveillance et d'utilisation de l'interface impédancemétrique. Selon cette autre possibilité de configuration, le dispositif de surveillance peut comporter :

- un circuit électrique de surveillance comprenant la première électrode de contact manuel de l'interface impédancemétrique et l'organe actif, le circuit électrique de surveillance étant susceptible d'être fermé, lors d'un contact simultané de l'utilisateur avec ladite première électrode de contact manuel et avec l'organe actif,
- un générateur électrique d'un courant de surveillance dans le premier circuit électrique,
- un dispositif de mesure d'une tension de surveillance entre l'organe actif et la deuxième électrode de contact manuel,
- un comparateur d'au moins une caractéristique électrique de surveillance fonction de la tension de surveillance et d'une caractéristique électrique de seuil fonction d'une valeur d'impédance majorant une valeur d'impédance de conduction du corps humain, le comparateur étant relié au dispositif d'arrêt d'urgence pour provoquer un arrêt d'urgence lorsque la caractéristique électrique de surveillance franchit la caractéristique électrique de seuil.

Le dispositif de mesure d'une tension de surveillance entre l'organe actif et la deuxième électrode de contact manuel de l'interface impédancemétrique peut être, de préférence, un dispositif de mesure à haute impédance, tel qu'un voltmètre. Son impédance interne est supérieure de plusieurs ordres de grandeur aux impédances en jeu dans le circuit électrique de surveillance, de manière à ne pas perturber un courant circulant dans le circuit électrique de surveillance. Il s'agit, par exemple, d'une impédance interne supérieure à 10MΩ. La tension de surveillance est mesurée par rapport au potentiel de l'organe actif qui correspond, de préférence au potentiel de masse de l'outil. Elle peut également être mesurée ou déterminée par rapport à un potentiel fixe par rapport à la masse ou par rapport à l'organe actif.

La caractéristique électrique de surveillance peut être une caractéristique pouvant être exprimée sous la forme d'une tension, d'un courant, d'une valeur d'impédance ou encore d'une valeur de conductance. Elle est établie à partir de la tension de surveillance, en application de la loi d'Ohm.

Il en va de même pour la caractéristique de seuil, qui est établie à partir de l'impédance de conduction du corps humain et en particulier une valeur majorant une valeur d'impédance du corps humain. Elle peut également être établie sous la forme d'une tension, d'un courant, d'une valeur d'impédance ou d'une valeur de conductance, en application de la loi d'Ohm et d'une valeur d'impédance du circuit électrique.

Différentes formes d'expression de la caractéristique électrique de surveillance et de la caractéristique électrique de seuil sont explicitées dans la suite de la description.

Le circuit électrique de surveillance comprend, comme mentionné précédemment, la première électrode de contact manuel, et l'organe actif conducteur électrique. Il est fermé lorsque l'utilisateur touche à la fois la première électrode de contact manuel de l'interface impédancemétrique de l'outil et l'organe actif.

Par simplification, on considère toujours que l'utilisateur touche la première électrode de contact manuel de l'interface impédancemétrique avec l'une de ses mains, et qu'il touche l'organe actif avec un doigt de l'autre main, qui risque en l'occurrence d'être blessée. Ce choix n'implique cependant aucune limitation quant à la partie du corps qui touche l'organe actif.

Ainsi, lorsque l'utilisateur touche simultanément la première électrode de contact manuel de l'interface impédancemétrique et l'organe actif, un certain nombre d'impédances se trouvent en série dans le circuit de mesure entre la première électrode de contact manuel et l'organe actif. Il s'agit :

- de l'impédance de contact entre la main et la première électrode de contact manuel, notée $Z_{M1}$
- de l'impédance du corps de l'utilisateur, entre la main touchant la première électrode de contact manuel et le doigt de l'autre main, notée $Z_C$, et
- de l'impédance de contact entre le doigt et l'organe actif, notée $Z_D$.

Par ailleurs, dans le cas particulier où l'outil est un sécateur, on note $Z_V$, la somme de l'impédance de la végétation, par exemple celle de sarments de vigne, et de l'impédance de contact du doigt, ou plus généralement de la main, sur la végétation ou un objet tenu par la main libre de l'utilisateur et coupés par l'organe actif, en l'occurrence les lames. L'objet tenu peut être, le cas échéant un fil de fer de palissage. Pour d'autres outils la grandeur $Z_V$ caractérise l'impédance du matériau coupé ou usiné associée au contact du doigt avec ce matériau, dans l'hypothèse où ce matériau est touché par la main libre de l'utilisateur.

En négligeant les valeurs d'impédance propres de la première électrode de contact manuel et de l'organe actif, l'impédance totale notée ZT du circuit électrique de surveillance pourra prendre trois valeurs :

- une valeur infinie $Z_T = \infty$, lorsque l'organe actif n'est pas touché,
- une valeur $Z_T = Z_{M1} + Z_C + Z_D$ lorsque le doigt touche l'organe actif,
- une valeur $Z_T = Z_{M1} + Z_C + Z_V$ lorsqu'un matériau tenu par la main libre touche l'organe actif.

L'ordre de grandeur de la valeur de l'impédance $Z_C$ du corps de l'utilisateur, entre sa première main touchant l'interface impédancemétrique et son doigt de l'autre main susceptible de toucher l'organe actif, peut aisément être évalué. Il s'agit de la conductivité du corps humain dont l'impédance a une valeur Inférieure à dix mille Ohms. La valeur de l'impédance $Z_{M1}$ de contact de la main avec la première électrode de contact manuel, ainsi que la valeur de l'impédance de contact $Z_D$ entre le doigt et l'organe actif, ou l'impédance $Z_V$ comprenant l'impédance intermédiaire d'un matériau en contact avec l'organe actif peuvent présenter une grande variabilité et sont le plus souvent très supérieures à la valeur de l'impédance du corps de l'utilisateur, notamment en cas de pression de contact faible avec une partie de peau de la main ayant une faible conductivité.

Dans la suite de la description, il n'est fait référence qu'au contact direct du doigt avec l'organe actif. En effet, la situation du contact du doigt avec un matériau intermédiaire ne génère pas de risque pour l'utilisateur. Elle peut éventuellement déclencher le dispositif d'arrêt d'urgence lorsqu'une valeur d'impédance $Z_V$ est proche de $Z_D$, c'est-à-dire lorsque le matériau intermédiaire est bon conducteur électrique.

Cependant, quand le contact du doigt avec l'organe actif est proche d'un risque de blessure, la valeur de l'impédance de contact du doigt $Z_D$ peut être évaluée comme étant du même ordre de grandeur voire devenir inférieure à la valeur de l'impédance $Z_C$ du corps de l'utilisateur. On peut se reporter à ce sujet à la description qui précède.

On estime là encore, que la valeur de l'impédance de contact au niveau de l'organe actif en cas de contact sérieux est inférieure à la valeur de l'impédance du corps humain. Une détection d'une impédance de l'ordre de grandeur de l'impédance du corps humain permet alors d'identifier avec une très grande probabilité l'existence d'un contact instantané et non souhaité de l'utilisateur avec l'organe actif.

Il n'en est pas de même de l'impédance de contact $Z_{M1}$ entre la main de l'utilisateur et de la première électrode de contact manuel, dont la valeur peut varier dans des proportions plus importantes, et masquer de fait l'occurrence d'un contact entre le doigt de l'utilisateur et l'organe actif.

Le dispositif de mesure de l'invention permet de s'affranchir de l'impédance de contact $Z_{M1}$ entre la main de l'utilisateur et la première électrode de contact manuel. Ceci a lieu en mesurant une tension sur la deuxième électrode de contact manuel de l'interface impédancemétrique. La deuxième électrode de contact manuel de l'interface impédancemétrique est reliée à la première électrode de contact manuel par l'intermédiaire de la main de l'utilisateur qui touche l'interface impédancemétrique. Les électrodes de contact manuel sont ainsi reliées par deux impédances potentiellement élevées en série. Il s'agit de l'impédance $Z_{M1}$ de contact de la main avec la première électrode de contact manuel et d'une impédance $Z_{M2}$ de contact de la main avec la deuxième électrode de contact manuel de l'interface impédancemétrique. Ainsi on considère également que la deuxième électrode de contact manuel est reliée à l'impédance du corps de l'utilisateur par l'impédance de contact de la main avec la deuxième électrode de contact manuel. En raison de l'impédance interne élevée du dispositif de mesure de tension, la tension $V_{E2}$ mesurée sur la deuxième électrode de contact manuel, ou plus précisément la différence de potentiel entre cette électrode et la masse de l'outil est sensiblement égale à une différence de potentiel Vc qui serait mesurée en un point fictif interne de la main de l'utilisateur noté C et l'organe actif relié à la masse de l'outil. En effet un courant nul ou quasi nul circule entre ce point fictif interne et la deuxième électrode de contact manuel de l'interface impédancemétrique, assurant la quasi égalité des potentiels $V_{E2}$ et Vc, ces deux tensions pouvant être considérées comme constituant la tension de surveillance.

Le générateur électrique d'un courant de surveillance a pour fonction de faire circuler dans le circuit de surveillance un courant de surveillance Is, lorsque le circuit de surveillance est fermé, c'est à dire lors d'un contact, direct ou indirect, de l'utilisateur avec l'organe actif.

Le générateur électrique peut comporter, par exemple, une source de courant. Il peut aussi comporter une source de tension. La source de courant ou la source de tension peuvent être connectées en série dans le circuit de surveillance.

Le générateur électrique du courant de surveillance peut disposer d'une alimentation autonome, par exemple une pile électrique. Il peut aussi être alimenté en énergie par une source d'alimentation électrique, par exemple une batterie d'alimentation, de l'outil, lorsque l'outil est un outil pourvu d'un moteur d'entrainement électrique.

Lorsque le générateur électrique comporte une source de courant, l'intensité du courant lorsque le circuit est fermé est connue. Elle correspond alors à l'intensité du courant de surveillance Is.

L'outil peut aussi comporter, en série dans le circuit électrique une impédance électrique d'ajustement présentant une valeur d'impédance prédéterminée et connue $Z_1$ ainsi qu'un dispositif de mesure d'une tension $V_1$ aux bornes de l'impédance électrique d'ajustement. La mesure de cette tension permet alors également de connaitre l'intensité du courant de surveillance Is. En effet le courant de surveillance Is est égal au rapport de la tension mesurée aux bornes de l'impédance électrique d'ajustement sur la valeur de l'impédance électrique d'ajustement :

$$Is = V_1 / Z_1$$

Le choix de la valeur de l'impédance d'ajustement $Z_1$, est susceptible d'influencer l'intensité du courant circulant dans le circuit de surveillance. Elle n'est pas critique toutefois, sa fonction étant essentiellement de déterminer l'intensité du courant de surveillance. Par exemple, la valeur de l'impédance d'ajustement peut être choisie entre $1\Omega$ et $200k\Omega$.

Le dispositif de mesure est, par exemple un voltmètre, et en particulier un voltmètre intégré à une carte électronique comprenant en outre le comparateur.

Il est ainsi possible de connaître l'impédance Z cumulée du corps de l'utilisateur à partir de la mesure de $V_{E2}$ et du courant de surveillance Is circulant dans le circuit électrique de surveillance.

On a :

$$Z = Z_C + Z_D$$

et

$$V_{E2} = Is \times Z.$$

Soit :

$$Z = V_{E2} / Is$$

Cette impédance peut être comparée à une valeur d'impédance de seuil Zseuil majorant la valeur d'impédance Zc du corps humain, et majorant de préférence d'un facteur 3 la valeur d'impédance Zc du corps humain. En particulier la valeur majorant l'impédance du corps humain peut être choisie égale à $20k\Omega$, et de préférence supérieure à $100k\Omega$.

La caractéristique électrique de surveillance peut être l'une parmi :

- une tension égale à la tension de surveillance, ou fonction de la tension de surveillance, la caractéristique électrique de seuil étant égale au produit de la valeur d'impédance majorant une valeur d'impédance de conduction du corps humain et du courant de surveillance,

- une valeur d'impédance fonction de la tension de surveillance et du courant de surveillance, la caractéristique de seuil étant une valeur d'Impédance fonction de la valeur d'impédance majorant une valeur d'impédance de conduction du corps humain,

- un rapport de la tension de surveillance sur le courant de surveillance, la caractéristique de seuil étant égale à la valeur d'impédance majorant une valeur d'impédance de conduction du corps humain.

Comme indiqué ci-dessus, la caractéristique électrique de surveillance peut être une tension fonction de la tension de surveillance et la caractéristique électrique de seuil peut être une tension de seuil fonction de la valeur d'impédance Zseuil majorant une valeur d'Impédance de conduction du corps humain et du courant de surveillance.

Dans le cas particulier où la caractéristique électrique de surveillance est égale à la tension de surveillance $V_{E2}$, la caractéristique électrique de seuil peut être égale à une tension Vseuil égale au produit de la valeur d'impédance majorant une valeur d'impédance de conduction du corps humain et du courant de surveillance.

On compare dans ce cas VE2 et Vseuil où

$$Vseuil = Zseuil \times Is$$

Lorsque $V_{E2}$>Vseuil le fonctionnement de l'outil est normal.

Lorsque $V_{E2}$<Vseuil ou $V_{E2}$=Vseuil, le dispositif d'arrêt d'urgence est déclenché.

Lorsque la caractéristique électrique de surveillance est une valeur d'impédance fonction de la tension de surveillance et du courant de surveillance, la caractéristique de seuil peut être une valeur d'impédance fonction de la valeur d'impédance Zseuil majorant une valeur d'impédance de conduction du corps humain.

En particulier, la caractéristique électrique de surveillance peut être égale à une impédance Z égale au rapport de la tension de surveillance sur le courant de surveillance, et la caractéristique de seuil peut être égale à la valeur d'impédance Zseuil majorant une valeur d'impédance de conduction du corps humain.

Dans ce cas lorsque Z>Zseuil le fonctionnement de l'outil est normal.

En revanche lorsque lorsque Z<Zseuil ou Z=Zseuil, le dispositif d'arrêt d'urgence est déclenché.

D'autres caractéristiques de surveillance et de seuil comme des fonctions affines des grandeurs précitées peuvent également être retenues. Il est encore possible de comparer des conductances.

La comparaison entre l'impédance Z et l'impédance Zseuil, ou, comme évoqué précédemment, la comparaison de la tension de surveillance $V_{E2}$ avec une tension Vseuil, ou encore, plus généralement la comparaison d'une autre caractéristique électrique de surveillance, fonction de la tension de surveillance, avec une caractéristique électrique de seuil, fonction d'une impédance majorant l'impédance du corps humain, est effectuée par le comparateur.

A cet effet, la valeur Zseuil, la valeur Vseuil, ou plus généralement la valeur d'une caractéristique électrique de seuil fonction d'une impédance majorant l'impédance du corps humain, peut être stockée dans une mémoire reliée au comparateur. Les valeurs de seuil contenues dans la mémoire peuvent être fixées à la fabrication de l'outil. Un accès à la mémoire peut également être prévu pour modifier les valeurs de seuil de manière à modifier, au besoin, la sensibilité du déclenchement du dispositif d'arrêt d'urgence.

Lorsque le générateur électrique comporte une source de courant, celle-ci peut être connectée en parallèle à l'impédance d'ajustement, connectée en série dans le circuit électrique de surveillance. Comme mentionné précédemment, la loi d'Ohm permet alors de déterminer la valeur Is du courant circulant dans le circuit de surveillance.

Le générateur électrique peut être un générateur à courant alternatif ou un générateur à courant continu. Un générateur à courant alternatif présente, par exemple, une fréquence de fonctionnement de 10kHz. Comme indiqué précédemment, l'utilisation d'un courant de surveillance alternatif permet au dispositif de fonctionner lorsque l'organe actif, conducteur, est recouvert d'une couche d'isolant électrique.

Accessoirement l'outil peut comporter une impédance de mise à la masse, d'une valeur dépassant de plusieurs ordres de grandeur la valeur d'impédance majorant la valeur d'impédance du corps humain, l'impédance de mise à la masse reliant électriquement la deuxième électrode de contact manuel à l'organe actif. Dans ce cas, l'outil peut être configuré pour provoquer en outre l'un parmi un arrêt d'urgence et une mise hors service, lorsque la tension de surveillance mesurée par le dispositif de mesure est nulle. L'impédance de mise à la masse permet d'éviter un potentiel flottant de la deuxième électrode de contact manuel. Sa valeur est très élevée, par exemple de plusieurs millions d'Ohms, de manière à ne pas introduire de courant significatif dans la deuxième électrode de contact manuel, et ainsi à ne pas affecter la mesure de la tension de surveillance. Par ailleurs, grâce à l'impédance de mise à la masse, il est possible, en absence de contact de la main simultanément sur la première et la deuxième électrode de contact manuel, d'avoir une tension de surveillance nulle au niveau de la deuxième électrode. La mesure d'une tension $V_{E2}$ nulle permet alors, comme indiqué ci-dessus de déclencher le dispositif d'arrêt d'urgence, ou une simple mise hors service, pour interdire l'utilisation de l'outil.

Il convient de noter que l'utilisateur peut au besoin porter des gants conducteurs électriques, notamment pour se protéger du froid. On estime dans ce cas que le contact de la main avec le gant ne génère pas de variations d'impédance significatives, et notamment supérieures aux variations d'un contact direct de la main avec les électrodes de contact manuel de l'interface impédancemétrique.

D'autres caractéristiques et avantages de l'invention ressortiront de la description qui suit en référence aux figures des dessins. Cette description est donnée à titre illustratif et non limitatif.

**Brève description des figures**

Les figures 1 et 2 sont des représentations simplifiées d'un dispositif de commande conforme à l'invention avec un organe de commande en position de repos.

Les figures 3 et 4 sont des représentations des dispositifs des figures 1 et 2, avec un organe de commande en position de fonctionnement ou de travail.

Les figures 5A, 5B et 5C sont respectivement une perspective, une vue latérale et une section transversale selon un plan A-A d'un bouton poussoir formant un organe de commande d'un dispositif de commande conforme à l'invention.

Les figures 6A, 6B et 6C sont respectivement une perspective, une vue latérale et une section transversale selon un plan B-B d'une gâchette à levier formant un organe de commande d'un dispositif de commande conforme à l'invention.

La figure 7 est une représentation schématique fonctionnelle illustrant une possibilité d'exécution d'un outil motorisé sécurisé conforme à l'invention et utilisant le dispositif de commande.

La figure 8 est une représentation schématique fonctionnelle illustrant une autre possibilité d'exécution d'un outil motorisé sécurisé conforme à l'invention et utilisant le dispositif de commande.

Les figures sont exécutées en échelle libre.

## Description détaillée de modes de mise en œuvre de l'invention

Dans la description qui suit, des parties identiques, similaires ou équivalentes des différentes figures sont repérées avec les mêmes signes de référence de manière à faciliter le report d'une figure à l'autre.

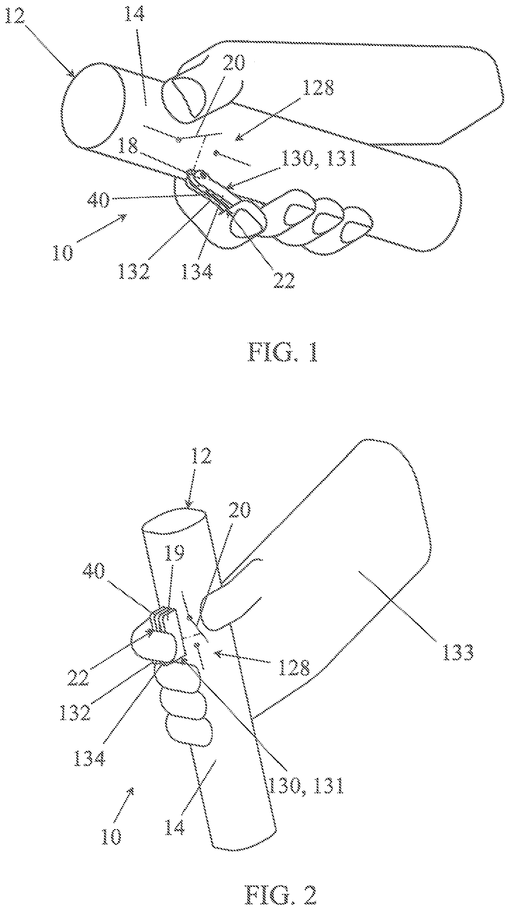

Les figures 1 à 4 montrent un dispositif de commande 10 pour un outil 12 comportant un organe actif, dont seule toutefois une poignée 14 est représentée. La poignée est tenue par la main d'un utilisateur. Le dispositif de commande comprend une interface de commande de fonctionnement 128.

L'Interface de commande de fonctionnement 128 comprend un organe de commande 130 à actionnement manuel et un ou plusieurs composants électriques 20 actionnés par l'organe de commande pour délivrer ou modifier un signal de commande pour actionner l'organe actif.

Sur les figures 1 à 4, les composants électriques 20 de l'interface de commande de fonctionnement sont symbolisés par un simple interrupteur sans pour autant préjuger de la configuration de cet organe qui peut également comporter un gradateur, une interface optique ou d'autres composants permettant de former ou de modifier un signal de commande.

Dans le cas d'un outil électrique, le signal de commande peut être dirigé vers une carte électrique d'alimentation d'un moteur électrique d'entrainement de l'organe actif, gouvernant l'alimentation électrique du moteur en fonction du signal de commande.

Dans le cas d'un outil à moteur thermique l'interface de commande de fonctionnement peut être une interface de commande électrique ou mécanique.

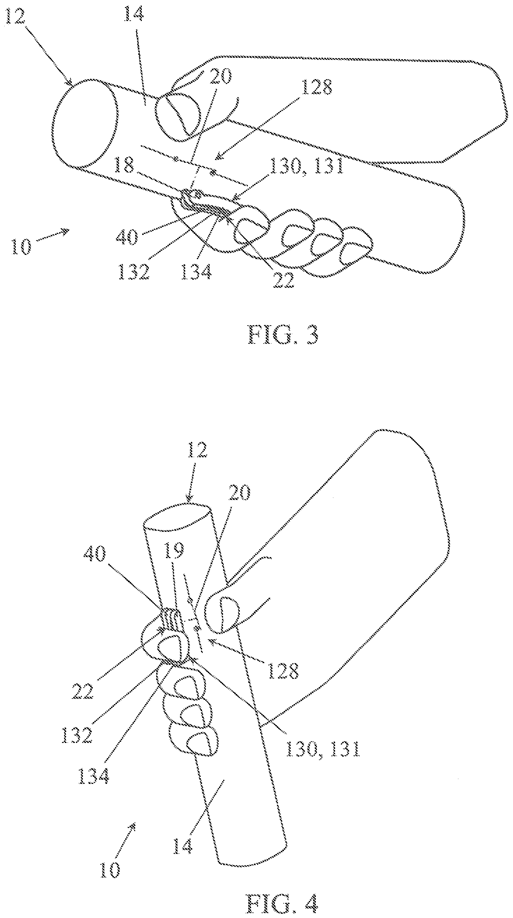

Les figures 1 et 3 montrent un organe de commande 130 comprenant une gâchette à levier 18 actionnable par un doigt de la main de l'utilisateur saisissant la poignée. Sur la figure 1 le doigt touche une plage d'appui manuel 22 de l'organe de commande 130 sans pour autant enfoncer la gâchette à levier. Il s'agit d'une position de repos indexée de la gâchette à levier dans laquelle l'outil est au repos ou en veille.

Sur la figure 3 le doigt touchant la plage 22 d'appui manuel exerce une pression sur cette plage d'appui manuel. Il fait pivoter la gâchette à levier et l'interface de commande 128 émet ou modifie un signal mettant l'outil en fonctionnement. La position de l'organe de commande 130 de la figure 3 est désignée par position de fonctionnement.

De la même manière, les figures 2 et 4 montrent un organe de commande 130 comprenant un bouton poussoir 19 également actionné par un doigt de la main tenant la poignée. Le doigt est représenté en contact avec une plage d'appui manuel 22 de l'organe de commande. La figure 2 correspond au bouton poussoir dans une position de repos dans laquelle le bouton poussoir fait saillie sur le manche 14. La figure 4 correspond à l'organe de commande dans une position de fonctionnement : le bouton poussoir 19 est enfoncé dans le manche 14 par la pression exercée par le doigt en contact avec la plage d'appui manuel 22.

Le bouton poussoir 19 ou la gâchette à levier 18 constituent l'organe de commande 130 à actionnement manuel et font partie de l'interface de commande de fonctionnement 128 mais constituent également une interface impédancemétrique 131 décrite ci-après.

On peut observer que la main de l'utilisateur sur la figure 2 est revêtue d'un gant conducteur électrique 133. Ce gant fait partie de l'interface de commande de fonctionnement, ou, pour le moins, y est associé. Il permet d'améliorer le contact de la main ou du doigt avec l'interface impédancemétrique 131. On peut noter que seule la partie du gant en contact avec l'interface impédancemétrique pourrait être revêtue d'un revêtement conducteur. Le revêtement conducteur n'est toutefois pas seulement extérieur au gant pour rentrer en contact avec l'interface impédancemétrique, il est également intérieur au gant, de manière à venir aussi en contact avec la peau de l'utilisateur. Le revêtement conducteur extérieur et le revêtement conducteur intérieur sont alors reliés électriquement pour mettre la main de l'utilisateur en contact électrique avec l'interface impédancemétrique. Pour éviter un contact imparfait entre le revêtement conducteur intérieur du gant et la peau de l'utilisateur, le revêtement intérieur conducteur n'est, de préférence, pas limité à la seule partie venant en regard de l'interface impédancemétrique. Il est préférable que le gant soit conducteur sur une grande surface en contact avec la main pour assurer une impédance de contact faible entre la main de l'utilisateur et le gant, assurant ainsi une impédance de contact faible entre la main et l'interface impédancemétrique.

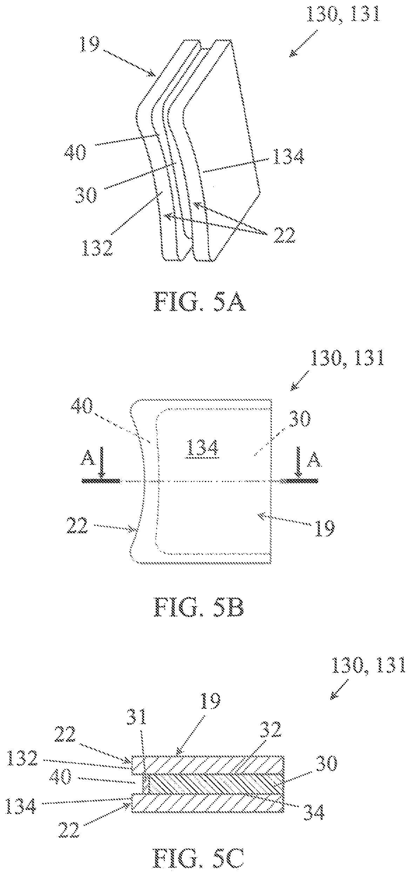

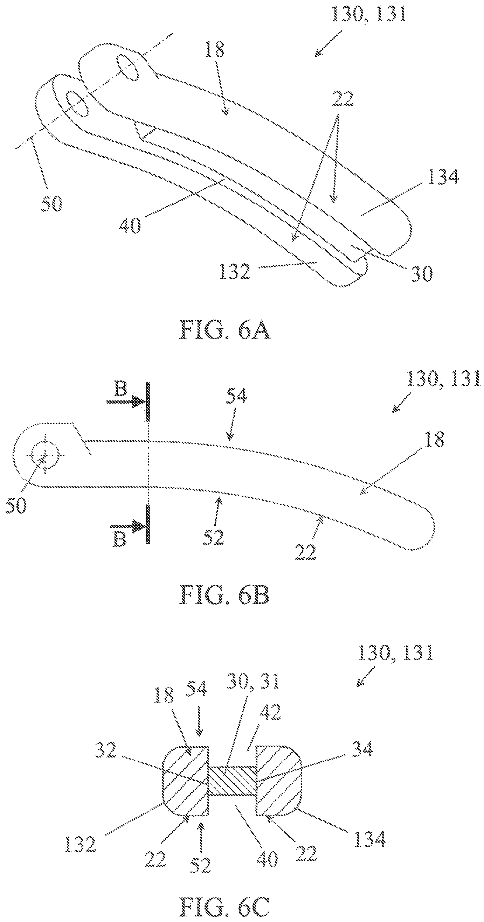

L'interface impédancemétrique 131 comprend pour l'essentiel une première électrode de contact manuel 132 et une deuxième électrode de contact manuel 134. Les électrodes de contact manuel de l'interface impédancemétrique 131 apparaissent mieux sur les figures 5A, et 5C ainsi que sur les figures 6A et 6C.

La figure 5A est une perspective d'une possibilité de réalisation particulière de l'organe de commande 130 à actionnement manuel et plus précisément d'un bouton poussoir 19 qui constitue la partie de l'organe de commande dépassant du manche de l'outil.

La figure 5C est une coupe du bouton poussoir selon une section A-A indiquée sur la figure 5B, représentant une vue latérale du bouton poussoir. Elle montre que le bouton poussoir présente un corps central 30 isolant électrique, par exemple en matière plastique, dont les flancs latéraux 32, 34 reçoivent des garnitures métalliques formant les électrodes de contact manuel 132, 134. Le corps central 30 peut également comporter ou constituer un séparateur. Il comporte dans ce cas un matériau absorbant l'humidité comme une céramique poreuse, ou un matériau hydrophobe tel que du PTFE, du PVDF, un revêtement du type Teflon ou une mousse à cellules fermées en matériau hydrophobe. La figure 5C montre le corps central 30 recouvert d'un tel séparateur 31 en Teflon.

La référence 22 indique la plage d'appui du bouton poussoir 19. Comme le montrent les figures 5A, 5B et 5C, le corps central 30 du bouton poussoir est en retrait par rapport aux électrodes de contact manuel de manière à ménager un relief en creux 40 entre les électrodes de contact manuel. Le relief en creux s'étend longitudinalement sur le bouton poussoir et s'étend sur la plage d'appui manuel.

Par retour aux figures 1 à 4 on peut noter que lors d'un actionnement de l'organe de commande 130 le doigt de l'utilisateur s'étend perpendiculairement au relief en creux 40 de manière à relier entre elles les électrodes de contact manuel.

Les figures 6A, 6B et 6C montrent une autre possibilité de réalisation de l'organe de commande 130 à actionnement manuel dans lequel celui-ci comprend une gâchette à levier 18. Le levier 18 présente un axe de pivotement 50 et est monté sur un pivot de l'outil non représenté. On note ici que le pivot de l'outil est réalisé en une matière plastique ou une céramique isolante, de manière à ne pas relier électriquement les électrodes de contact manuel. Le pivot peut être aussi en matière métallique. Dans ce cas, cependant, les électrodes sont configurées pour ne pas rentrer en contact avec le pivot, de manière à ne pas être reliées électriquement par le pivot.

Les figures 6A et 6C montrent que le levier 18 comprend un corps central 30 dont des flancs opposés reçoivent des garnitures métalliques formant les électrodes de contact manuel 132, 134. Le corps central est en un matériau isolant électrique, par exemple une matière plastique. Un premier relief en creux 40 se présente sous la forme d'une rainure longitudinale. Celle-ci parcourt longitudinalement une première face 52 du levier 18, formant la plage d'appui manuel 22. Le premier relief en creux 40 s'étend entre les électrodes de contact manuel 132, 134 et parallèlement aux électrodes de contact manuel. Il est formé par un retrait du corps central 30 par rapport à la plage d'appui manuel 22.

La figure 6C montre une coupe du levier 18 selon une section B-B indiquée sur la figure 6B, représentant une vue latérale du levier. Comme le montre la figure 6C, un deuxième relief en creux 42 s'étend similairement sur une deuxième face 54 opposée à la première face 52, en parcourant également le levier de manière longitudinale entre les électrodes de contact manuel. Dans l'exemple de la figure 6C, le corps central 30 est entièrement réalisé en un matériau isolant électrique absorbant l'humidité ou un matériau isolant électrique hydrophobe. Il constitue ainsi un séparateur 31 au sens de l'invention.

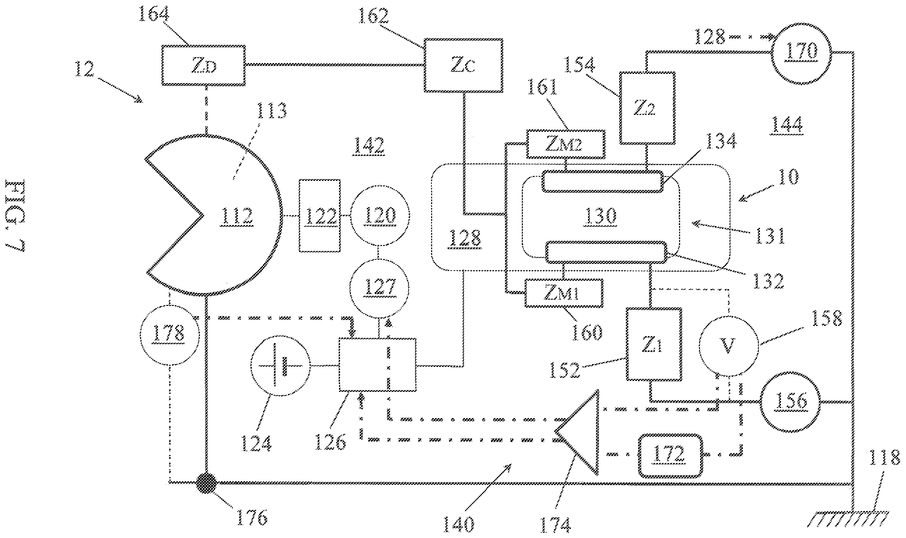

La figure 7 montre de manière schématique un outil motorisé de sécurité 12 pourvu d'un dispositif d'arrêt d'urgence et utilisant un dispositif de commande tel que précédemment décrit. L'outil 12 est pourvu d'un organe actif 112. Il s'agit par exemple d'un sécateur électrique dont l'organe actif est un organe de coupe formé d'une lame mobile susceptible de se refermer sur un crochet, de manière à sectionner une branche ou un rameau pris entre la lame et le crochet. La lame et le crochet sont des parties métalliques et conductrices électriques. Elles peuvent être recouvertes éventuellement d'une couche de polymère isolante électrique 113 pour les protéger de la corrosion et faciliter leur glissement l'une contre l'autre.

L'organe actif 112 est relié électriquement à la masse 118 de l'outil constituant un potentiel de référence.

L'outil 12 comprend en outre un moteur d'entraînement électrique 120 relié mécaniquement à l'organe actif 112, par un mécanisme de transmission 122.

Le moteur d'entraînement 120 est associé à une alimentation électrique 124 et à une carte électronique 126 de commande du moteur. La carte électronique de commande 126 reçoit des signaux de l'interface de commande de fonctionnement 128 du dispositif de commande 10. L'interface de commande de fonctionnement comprend l'organe de commande 130 à actionnement manuel représenté schématiquement.

Un dispositif d'arrêt d'urgence 140 du moteur d'entraînement électrique 120 de l'outil est gouverné par deux circuits électriques 142, 144. Les circuits électriques 142, 144 incluent des composants de l'outil, et en particulier l'organe actif 112, mais peuvent également inclure des parties du corps d'un humain utilisant l'outil.

Le premier circuit électrique 142 comprend en série, un composant formant une première impédance électrique 152 une première électrode 132 de contact manuel et l'organe actif 112.

La première impédance électrique 152, dont la valeur est notée $Z_1$ peut être un simple composant électronique comme une résistance électrique. Sa valeur est définie de préférence égale ou supérieure à 100kΩ.

Le premier circuit électrique 142 est normalement un circuit ouvert ayant, par conséquent une impédance globale quasi-infinie.

Lorsqu'un utilisateur touche l'interface impédancemétrique 131 du dispositif de commande 10, sa main vient en contact des électrodes de contact manuel 132,134 et donc de la première électrode de contact manuel 132. Le premier circuit électrique 142 reste ouvert.

En revanche, lorsque l'utilisateur touche également l'organe actif 112, par exemple avec un doigt de sa main libre, il ferme le premier circuit électrique 142. Dans ce cas, la première impédance électrique 152 se trouve en série successivement avec la première électrode de contact manuel 132, une impédance de contact 160 de la main ou du doigt de l'utilisateur avec la première électrode de contact manuel 132, une impédance 162 du corps de l'utilisateur, une impédance de contact 164 du doigt avec l'organe actif 112, et finalement l'organe actif 112 lui-même. On peut noter ici que, dans le cas où l'outil 12 est un sécateur, le circuit serait aussi fermé si l'utilisateur touchait indirectement l'organe actif 112, en l'occurrence une lame, par l'intermédiaire d'un conducteur comme une branche, un sarment de vigne voire un fil de fer de palissage qui serait en train d'être coupé. Cette situation ne fait que rajouter une impédance supplémentaire dans le circuit et ne remet pas en cause le fonctionnement. Par simplification, seul le cas d'un contact direct du doigt avec l'organe actif est évoqué par la suite.

Les valeurs de l'impédance de contact 160 de la main ou du doigt touchant l'interface impédancemétrique, de l'impédance 162 du corps et de l'impédance de contact 164 du doigt avec l'organe actif sont notés respectivement $Z_{M1}$, $Z_C$ et $Z_D$.

Ainsi lorsque le premier circuit est fermé une impédance totale $Z_{142}$ est telle que :

$$Z_{142} = Z_1 + Z_{M1} + Z_C + Z_D$$

L'impédance du câblage et celle de l'organe de coupe sont négligées ici.

Un dispositif de mesure d'une caractéristique d'impédance du premier circuit électrique est prévu. Dans l'exemple de réalisation de la figure 7, il comprend un générateur électrique 156 sous la forme d'une source de courant alternatif, en série avec le premier circuit 142, et un voltmètre 158 connecté en parallèle avec la première impédance 152. La valeur de tension mesurée par le voltmètre est, dans ce cas, la caractéristique d'impédance du premier circuit, au sens de l'invention.

Un deuxième circuit électrique 144 comprend la première impédance électrique 152, la première électrode de contact manuel 132, la deuxième électrode de contact manuel 134 et une deuxième impédance électrique 154.

Tout comme la première impédance électrique, la deuxième impédance électrique peut être formée par un composant électronique comme une simple résistance d'une valeur définie, de préférence supérieure à 100kΩ. Sa valeur d'impédance, qu'elle soit réelle ou complexe, est notée $Z_2$.

Le deuxième circuit électrique est également un circuit ouvert lorsque l'utilisateur ne touche pas l'interface impédancemétrique 131 de l'outil 12. Les électrodes de contact manuel 132, 134 sont en effet électriquement isolées l'une de l'autre.

En revanche, lorsque l'utilisateur pose un doigt ou sa main sur l'interface impédancemétrique 131 de l'organe de commande 130, son doigt ou sa main viennent relier électriquement la première et la deuxième électrode de contact manuel 132, 134 de l'interface impédancemétrique 131. Une impédance de contact 160 de la main ou du doigt de l'utilisateur avec la première électrode de contact manuel 132, de valeur $Z_{M1}$, et une impédance de contact 161, d'une valeur notée $Z_{M2}$ de la main ou du doigt de l'utilisateur avec la deuxième électrode de contact manuel 134 de l'interface impédancemétrique 131 viennent alors s'ajouter en série dans le deuxième circuit.

Dans ce cas l'impédance $Z_{144}$ du deuxième circuit électrique 144 est telle que :

$$Z_{144} = Z_1 + Z_2 + Z_{M1} + Z_{M2}$$

Or, les valeurs $Z_{M1}$ et $Z_{M2}$ sont issues de contacts de même nature et leurs variations sont donc similaires. Il en est de même de la valeur de $Z_D$ dans le premier circuit et chaque circuit comporte ainsi deux valeurs d'impédance de contact de même nature. Une comparaison de $Z_{142}$ et $Z_{144}$ permet alors de s'affranchir des variations des impédances de contact avec les électrodes de contact manuel, et de mesurer l'occurrence d'un contact du doigt de l'utilisateur avec l'organe actif 112 en évaluant $Z_C$ et $Z_D$ en regard de $Z_2$ et $Z_{M2}$.

Un dispositif de mesure est également prévu pour établir une caractéristique d'impédance du deuxième circuit électrique. Il s'agit, dans l'exemple de réalisation décrit, du générateur électrique 156 et du voltmètre 158 déjà mentionnés et utilisés également en lien avec le premier circuit électrique 142. La tension mesurée aux bornes de la première impédance électrique 152 est une valeur de la caractéristique du deuxième circuit électrique 144.

Comme un unique dispositif de mesure est prévu pour mesurer les caractéristiques d'impédance du premier et du deuxième circuit électrique 142,144 une mesure alternée est prévue.

A cet effet, le deuxième circuit électrique 144 comprend un interrupteur 170 permettant d'ouvrir ou de fermer le deuxième circuit électrique. L'interrupteur 170 peut être du type électromécanique, ou, de préférence, un interrupteur électronique à transistor.

L'interrupteur 170 est asservi à l'interface de commande de fonctionnement 128 de manière à être fermé dans la position de repos et de manière à être ouvert dans la position de fonctionnement.

En l'absence de commande de fonctionnement, le risque de coupure de l'utilisateur par l'organe actif est faible ou inexistant. Le premier circuit est ouvert en supposant que l'utilisateur ne touche pas l'organe actif 112. L'interrupteur 170 du deuxième circuit est alors fermé et permet une mesure de la caractéristique du deuxième circuit électrique 144. Une caractéristique électrique de valeur singulière peut toutefois être mesurée dans le cas où l'utilisateur ne touche pas simultanément les deux électrodes de contact manuel, et donc quand le circuit 144 est ouvert malgré la fermeture de l'interrupteur 170.

Lorsque l'utilisateur actionne l'organe de commande 130, par exemple, par l'enfoncement d'un bouton poussoir ou d'une gâchette à levier, l'interrupteur 170 du deuxième circuit électrique 144 est ouvert de manière à permettre une mesure de la caractéristique d'impédance du premier circuit électrique 142.

A chaque mesure de la caractéristique d'impédance du deuxième circuit électrique 144, la valeur de cette caractéristique d'impédance, ou une valeur proportionnelle à la caractéristique d'impédance est mise à jour et conservée dans une mémoire 172 jusqu'à une prochaine mesure. Les mesures de la caractéristique d'impédance du deuxième circuit électrique 144, et la mise à jour de la mémoire 172 peuvent être effectuées à chaque fermeture de l'interrupteur 170 du deuxième circuit électrique, ou à intervalles de temps prédéterminés lorsque ledit interrupteur reste fermé.

La valeur mémorisée constitue une caractéristique de seuil.

La mémoire 172 est reliée à une entrée d'un comparateur 174 de manière à fournir la caractéristique de seuil comme valeur de référence.

Une deuxième entrée du comparateur 174 reçoit la caractéristique d'impédance du premier circuit électrique lors d'une commande de fonctionnement, c'est-à-dire lorsque l'interrupteur 170 du deuxième circuit électrique 144 est ouvert.

La caractéristique d'impédance du premier circuit électrique est ainsi comparée à la valeur de seuil.

Une sortie du comparateur 174 est reliée à la carte électronique de commande 126 du moteur d'entrainement 120. En cas de dépassement de la valeur de seuil par valeur supérieure ou inférieure, selon la caractéristique d'impédance choisie, le comparateur émet un signal d'arrêt en direction de la carte électronique de commande du moteur d'entrainement. Le signal d'arrêt est utilisé par la carte électronique pour déclencher un arrêt d'urgence du moteur d'entrainement et de l'opération de coupe. L'arrêt d'urgence peut comporter, par exemple, une ouverture d'un circuit d'alimentation électrique du moteur d'entrainement, ou un pilotage du moteur pour bloquer le mouvement de l'organe de coupe. Accessoirement, le comparateur peut aussi émettre un tel signal d'arrêt en cas de présence d'une valeur singulière dans la mémoire 172, signifiant un défaut de contact simultané des deux électrodes de contact manuel de l'interface impédancemétrique 131. Une telle situation est en effet susceptible de compromettre une détection d'un contact inopiné de l'utilisateur avec l'organe actif.

La carte électronique de commande 126 du moteur d'entrainement fait ainsi partie du dispositif d'arrêt d'urgence 140. Le dispositif d'arrêt d'urgence peut aussi comporter un interrupteur 127 d'ouverture d'un circuit d'alimentation électrique du moteur d'entrainement.

Dans une réalisation particulièrement simple de l'outil de coupe, la première impédance électrique 152 et la deuxième impédance électrique 154 peuvent être fixées à une même valeur $Z1=Z2$, de l'ordre de 100k$\Omega$ ou 200k$\Omega$. Ces valeurs sont nettement supérieures à une impédance estimée du corps humain et à une impédance estimée de contact du doigt avec l'organe de coupe.

Une impédance du corps humain est estimée inférieure à 10k$\Omega$. Il en va de même de l'impédance de contact du doigt avec l'organe actif qui est estimée inférieure à 10k$\Omega$, et plutôt d'un ordre de grandeur de 1k$\Omega$, notamment suite à une blessure naissante.

Dans cet exemple de réalisation, la caractéristique de seuil $Z_{seuil}$ retenue est directement l'impédance mesurée du deuxième circuit, soit :

$$Z_{seuil} = Z_{144} = Z_1 + Z_2 + Z_{M1} + Z_{M2}.$$

Lorsque le premier circuit électronique est ouvert, son impédance $Z_{142}$ est quasi infinie et $Z_{142} > Z_{seuil}$

En revanche, lorsque l'utilisateur touche simultanément l'interface impédancemétrique 131 et l'organe actif 112, l'impédance du premier circuit électrique devient :

$$Z_{142} = Z_1 + Z_{M1} + Z_C + Z_D$$

Le comparateur 174 compare ainsi: $Z_1 + Z_{M1} + Z_C + Z_D$ et $Z_1 + Z_{M1} + Z_{M2} + Z_2$.

En éliminant $Z_1$ et $Z_{M1}$ dans les deux impédances totales, ceci revient à comparer la somme de l'impédance du corps de l'utilisateur et de l'impédance de contact avec l'organe actif à l'impédance électrique $Z_2$, majorée d'une valeur $Z_{M2}$.

Ainsi, comme $Z_2$ est choisie supérieure à la somme des valeurs estimées de $Z_C$ et $Z_D$, la somme

$Z_M+Z_2$ est supérieure à la somme de $Z_C$ et $Z_D$ et on a alors: $Z_{142}<Z_{seuil}$

Le seuil est franchi et le comparateur délivre un signal d'arrêt d'urgence.

La référence 176 désigne une électrode de contrôle reliée électriquement à l'organe actif 112. Elle est prévue pour permettre un test de l'arrêt d'urgence sans toucher l'organe actif. Il suffit en effet que l'utilisateur, touchant l'interface impédancemétrique, touche simultanément avec sa main libre l'électrode de contrôle 176 pour provoquer un arrêt d'urgence. La carte électronique de commande 126 peut éventuellement être configurée pour requérir une telle opération de contrôle périodique, de manière à garantir le bon fonctionnement du dispositif d'arrêt d'urgence.

Un circuit de surveillance 178 du potentiel de l'organe de coupe est également prévu. Il est construit autour d'un voltmètre et est relié également à la carte électronique de commande 126 du moteur d'entrainement électrique 120 pour provoquer un arrêt d'urgence lorsqu'un potentiel électrique de l'organe de coupe devient différent d'une valeur de consigne. Dans l'exemple de réalisation illustré, on vérifie que le potentiel électrique de l'organe de coupe est au potentiel de référence de l'outil.

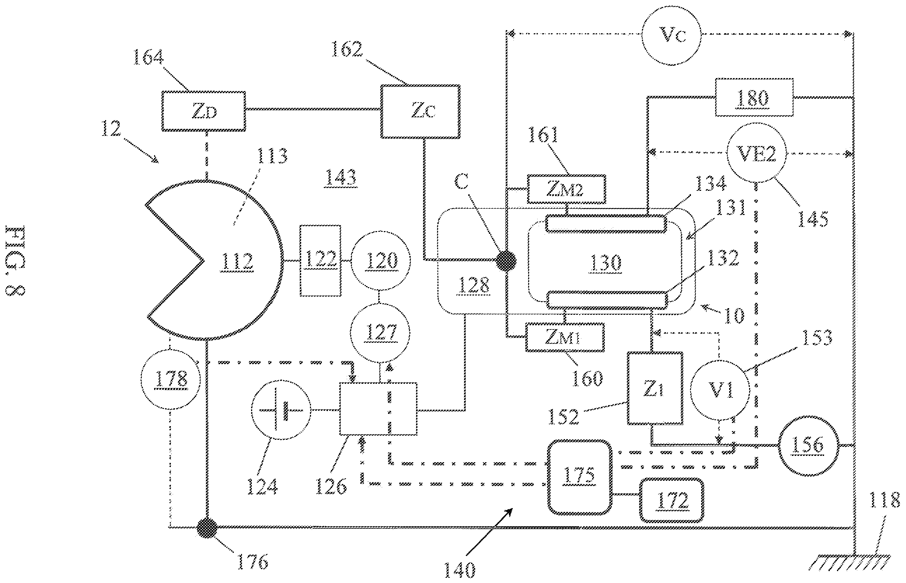

Une autre possibilité d'exécution de l'outil 12 est illustrée par la figure 8 et décrite ci-après.

L'outil 12 de la figure 8 présente un certain nombre d'organes communs avec celui de la figure 7 dont la description n'est pas reprise ici. Il est possible de se reporter à la figure 7 et à la description qui précède.

Un dispositif d'arrêt d'urgence 140 du moteur d'entrainement électrique 120 de l'outil 12 est gouverné par un circuit électrique de surveillance 143. Comme pour l'outil de la figure 7, le circuit électrique de surveillance 143 inclut des composants de l'outil 112 mais peut également inclure des parties du corps d'un humain utilisant l'outil.

Le circuit électrique de surveillance 143 comprend notamment, en série, une impédance d'ajustement 152, la première électrode 132 de contact manuel de l'interface impédancemétrique 131, l'organe actif 112 et un générateur électrique 156 d'un courant de surveillance. Le générateur électrique peut être une source de tension ou de courant. Il s'agit, par exemple, d'une pile électrique ou d'une batterie électrique. L'impédance d'ajustement 152 peut être formée d'un ou de plusieurs composants électriques dont la valeur d'impédance électrique $Z_1$ est connue. Elle peut être éventuellement incluse dans le générateur électrique 156. Il s'agit, par exemple, d'une résistance électrique avec une valeur, par exemple, de 100kΩ. Sa valeur n'est toutefois pas critique. Elle peut être comprise, par exemple, entre 1 Ω et 200kΩ. Une mesure de la tension V1 aux bornes de l'impédance d'ajustement 152 permet alors de déterminer un courant de surveillance Is circulant dans le circuit de surveillance.

L'impédance d'ajustement 152 n'est pas nécessaire quand le générateur électrique 156 est une source de courant. Lors d'une fermeture du circuit électrique de surveillance 143 le générateur fournit alors un courant de valeur définie Is. Dans la suite de la description le générateur est considéré comme une source de tension, sans toutefois préjuger de la possibilité de le remplacer par une source de courant.

En l'absence de contact avec un utilisateur, le circuit électrique de surveillance 143 est normalement un circuit ouvert ayant, par conséquent une impédance globale quasi-infinie et un courant nul.

Lorsqu'un utilisateur touche l'interface impédancemétrique 131, sa main ou son doigt viennent en contact avec les électrodes de contact manuel 132, 134 et donc de la première électrode de contact manuel 132. Le premier circuit électrique 143 reste ouvert.

En revanche, lorsque l'utilisateur touche également l'organe actif 112, par exemple avec un doigt de sa main libre, il ferme le circuit électrique de surveillance 143. Dans ce cas, l'impédance d'ajustement 152 se trouve en série successivement avec la première électrode de contact manuel 132, une impédance de contact 160 de la main ou du doigt de l'utilisateur avec la première électrode de contact manuel 132, une impédance 162 du corps de l'utilisateur, une impédance de contact 164 du doigt de l'utilisateur avec l'organe actif 112, et, finalement l'organe actif 112.

Les valeurs de l'impédance de contact 160 de la main ou du doigt avec la première électrode de contact manuel 162, de l'impédance 162 du corps et de l'Impédance de contact 164 du doigt avec l'organe actif sont notés respectivement $Z_{M1}$, $Z_C$ et $Z_D$.

Ainsi lorsque le premier circuit est fermé une impédance totale $Z_T$ est telle que :

$$Z_T = Z_1 + Z_{M1} + Z_C + Z_D$$

L'impédance du câblage et celle de l'organe actif sont négligées ici.

On néglige également l'impédance du générateur électrique 156 qui est considéré ici comme une source de tension.

Lorsque le circuit électrique de surveillance 143 est fermé, le générateur 156 fait circuler dans le circuit un courant de surveillance Is.

La valeur du courant Is peut être prédéfinie par le générateur de courant lorsqu'il comporte une source de courant. Elle peut aussi être déterminée à partir d'une mesure de tension effectuée aux bornes de l'impédance d'ajustement 152 lorsque le générateur comprend une source de tension, par exemple. La mesure de tension V1 aux bornes de l'impédance d'ajustement 152, de valeur $Z_1$, est effectuée par un voltmètre intégré 153.

Un dispositif de mesure de tension 145, par exemple un autre voltmètre intégré, est connecté entre la masse 118 de l'outil 12 et la deuxième électrode de contact manuel 134. Il mesure un potentiel VE2, ou plus précisément une tension de surveillance VE2 entre la masse 118 et la deuxième électrode de contact manuel 134.

La tension de surveillance VE2, de même que la tension délivrée par le voltmètre intégré 153 sont fournies à une unité de gestion numérique 175.

L'unité de gestion numérique, par exemple un microcontrôleur, ou un circuit intégré dédié, permet d'effectuer différentes opérations.

Une première opération consiste à calculer le courant de surveillance $I_s$ en effectuant un rapport $V1/Z_1$.

Une deuxième opération peut consister à calculer une valeur d'impédance Z à partir de la tension de surveillance et du courant de surveillance. En se référant à la description qui précède, on rappelle que :

$$Z = Z_C + Z_0 = VE2 \, / \, Is.$$

Enfin, et de manière principale, l'unité de gestion numérique 175 constitue un comparateur.

Elle peut notamment être utilisée pour comparer la valeur d'impédance Z à la valeur de seuil Zseuil majorant une valeur d'impédance du corps humain.

Elle peut encore être utilisée pour comparer la tension de surveillance VE2 à la tension de seuil Vseuil telle que Vseuil= Zseuil × Is.

Lorsque la tension chute sous la valeur de seuil de tension, ou lorsque l'impédance chute sous la valeur de seuil d'Impédance, la caractéristique électrique de seuil est respectivement franchie et l'arrêt d'urgence est déclenché.

Les comparaisons peuvent être effectuées sur d'autres paramètres fonction des paramètres précités et également calculés par l'unité de gestion numérique 175. Il est possible de comparer des conductances plutôt que des impédances, par exemple.

Suite à la comparaison, et lorsque la caractéristique électrique de seuil est franchie, par valeurs supérieures ou par valeurs inférieures selon la caractéristique choisie, le dispositif d'arrêt d'urgence 140 est déclenché.

Les caractéristiques électriques de seuil utilisés par le comparateur de l'unité de gestion numérique, par exemple les valeurs Vseuil ou Zseuil, peuvent être stockées dans une mémoire 172 associée à l'unité de gestion numérique 175.

Dans l'exemple de la figure 8 le dispositif d'arrêt d'urgence comporte également la carte électronique 126 de commande du moteur d'entrainement électrique 120. La carte électronique de commande 126 reçoit le signal d'arrêt d'urgence indiqué par un lien en trait mixte. La carte électronique de commande du moteur est dans ce cas configurée pour déclencher un mouvement du moteur d'entrainement propre à contrer le mouvement de l'organe actif 112 et/ou de manière à provoquer un freinage électromagnétique du moteur et de l'organe actif en utilisant les circuits inductifs du moteur électrique.

Un arrêt quasi instantané du mouvement de l'outil actif est ainsi obtenu.

Suite à l'arrêt de l'organe actif 112 une coupure de l'alimentation électrique peut également être opérée. Elle peut être effectuée par un Interrupteur 127, et en particulier un interrupteur à transistor, piloté par l'unité de gestion numérique 175.

Il convient de noter que l'unité de gestion numérique 175, et en particulier le comparateur qu'elle constitue, de même que la carte électronique 126 de commande du moteur d'entrainement 120, peuvent être réalisées sous la forme d'un unique composant intégré.

La référence 180 désigne une impédance de mise à la masse. Il s'agit dans l'exemple de la figure 8 d'une résistance électrique de plus de 1MΩ connectée entre la deuxième électrode de contact manuel 134 et la masse 118 de l'outil 12. Elle permet d'éviter une tension flottante de la deuxième électrode de contact manuel 134. Elle permet également de fixer la tension de la deuxième électrode de contact manuel 134 à une valeur nulle lorsque la deuxième électrode de contact manuel n'est pas en contact avec la main ou le doigt de l'utilisateur.

La mesure d'une tension de surveillance nulle par le dispositif de mesure de tension 145 peut ainsi être exploitée par l'unité de gestion numérique 175 pour interdire le fonctionnement de l'outil ou pour provoquer un arrêt d'urgence. Dans l'exemple de la figure 8, l'alimentation électrique du moteur d'entrainement 120 peut simplement être inhibée dans le cas de la mesure d'une tension de surveillance nulle.

Ceci permet, par exemple d'empêcher le fonctionnement de l'outil lorsqu'il est manœuvré par un utilisateur portant des gants isolants qui empêcheraient la détection d'un contact avec l'organe de coupe.

Quasiment aucun courant ne traverse l'impédance de mise à la masse 180 ou le doigt de l'utilisateur en contact avec la deuxième électrode de contact manuel 134 de l'interface impédancemétrique 131. Ainsi, le potentiel VE2 mesuré sur la deuxième électrode de contact manuel 134 est quasiment identique à un potentiel Vc qui serait mesuré entre un point fictif C à l'intérieur du corps de l'utilisateur qui touche l'interface impédancemétrique 131 et l'organe actif 112, et donc la masse de l'outil.

La référence 176 désigne une électrode de contrôle reliée électriquement à l'organe de coupe 12 de la manière déjà décrite en référence à la figure 7.

Un circuit de surveillance 178 du potentiel de l'organe de coupe est également prévu. Il est construit autour d'un voltmètre et est relié également à la carte électronique de commande 126 du moteur électrique 120 pour provoquer un arrêt d'urgence lorsqu'un potentiel électrique de l'organe actif 112 devient différent d'une valeur de consigne. Dans l'exemple de réalisation illustré, on vérifie que le potentiel électrique de l'organe de coupe est au potentiel de masse de l'outil. Le voltmètre peut être un composant intégré faisant partie d'une même carte électronique que l'unité de gestion numérique.

Dans la description qui précède le moteur d'entrainement de l'organe actif est un moteur électrique. Lorsque le moteur d'entrainement est un moteur thermique, la carte électronique de commande 126 peut être remplacée par une carte de commande de l'alimentation en carburant et/ou de l'allumage. Lorsque le moteur d'entrainement est un moteur thermique un frein électromagnétique ou électromécanique agissant sur le moteur 120, la transmission 122 ou directement sur l'organe actif 112 peut être piloté par le comparateur 174 de la figure 7 ou par l'unité de gestion numérique 175 de la figure 8 de manière à provoquer un arrêt d'urgence rapide. Le frein électromagnétique ou électromécanique n'est pas représenté sur les figures.

Dans le cas d'un moteur d'entrainement électrique, un freinage électromagnétique peut être opéré directement par le moteur 120 lui-même par exemple par mise en court-circuit de ses phases.

## Revendications

1. Dispositif de commande pour outil motorisé, comprenant:

   - une interface de commande de fonctionnement (128), pourvue d'un organe de commande (130) à actionnement manuel, présentant une plage d'appui manuel (22), pour un déplacement de l'organe de commande entre une position de repos et au moins une position de fonctionnement, **caractérisé par**
   - une interface impédancemétrique (131) de sécurité, comprenant une première électrode de contact manuel (132) et une deuxième électrode de contact manuel (134), électriquement isolées l'une de l'autre,

   et dans lequel les électrodes de contact manuel (132, 134) sont ménagées sur l'organe de commande (130) et s'étendent sur la plage d'appui manuel (22) de l'organe de commande.

2. Dispositif selon la revendication 1, dans lequel l'organe de commande (130) présente au moins l'un parmi un premier relief en creux (40), et un séparateur isolant électrique (31) comprenant un matériau choisi parmi un matériau absorbant l'humidité et un matériau hydrophobe, le premier relief en creux (40), respectivement le séparateur (31), s'étendant sur la plage d'appui manuel (22), entre la première électrode de contact manuel (132) et la deuxième électrode de contact manuel (134).

3. Dispositif selon la revendication 2, dans lequel le premier relief en creux (40) est un relief à bords angulaires.

4. Dispositif selon l'une quelconque des revendications 2 ou 3, dans lequel l'organe de commande (130) présente une forme allongée et dans lequel la première et la deuxième électrode (132, 134) de contact manuel, et ledit premier relief en creux (40), s'étendent longitudinalement sur l'organe de commande (130).

5. Dispositif selon l'une quelconque des revendications 2 à 4, dans lequel l'organe de commande (130) comprend l'un parmi une gâchette à levier (18), et un bouton poussoir (19).

6. Dispositif selon l'une quelconque des revendications 2 à 5, dans lequel l'organe de commande (130) comprend un levier (18), dans lequel le premier relief en creux (40) s'étend une première face (52) du levier formant la plage d'appui manuel (22).

7. Dispositif selon la revendication 6, dans lequel le levier (18) comprend au moins un deuxième relief en creux (42) s'étendant sur une deuxième face (54) du levier, opposée à la première face (52) du levier.

8. Dispositif selon l'une quelconque des revendications 2 à 5 dans lequel l'organe de commande comprend un corps central (30, 31) en matériau isolant électrique et des garnitures en un matériau conducteur électrique rapportées sur des flancs latéraux du corps central, les garnitures formant respectivement la première électrode de contact manuel (132) et la deuxième électrode de contact manuel (134) de l'interface impédancemétrique (131).

9. Dispositif selon l'une quelconque des revendications 1 à 8, dans lequel l'interface impédancemétrique (131) comprend en outre au moins un gant conducteur électrique (133) porté par un utilisateur du dispositif de commande.

10. Outil motorisé sécurisé (12) comprenant:

    un organe actif (112) conducteur électrique,

    - un dispositif de commande (10),
    - un moteur (120) d'entrainement de l'organe actif
    - un dispositif de surveillance (131, 142, 143, 144, 174, 175) à comparateur de caractéristiques électriques, sensible à un contact d'un utilisateur avec l'organe actif (112),
    - un dispositif d'arrêt d'urgence de l'organe actif (120, 126, 127), piloté par le dispositif de surveillance,

    **caractérisé en ce que** :

- le dispositif de commande (10) est conforme à l'une quelconque des revendications 1 à 9,
- le moteur d'entrainement de l'organe actif est commandé par l'intermédiaire de l'interface de commande de fonctionnement (128) du dispositif de commande (10) et
- le dispositif de surveillance comprend l'interface impédancemétrique (131) de sécurité du dispositif de commande (10).

11. Outil selon la revendication 10, dans lequel le dispositif de surveillance comporte :

   - un premier circuit électrique (142) comprenant la première électrode de contact manuel (132), une première impédance électrique (152) et l'organe actif (112), le premier circuit électrique (142) étant susceptible d'être fermé, lors d'un contact simultané de l'utilisateur avec ladite première électrode de contact manuel (132) et l'organe actif (112),
   - un deuxième circuit électrique (144) comprenant la première et la deuxième électrode de contact manuel (132, 134), la première impédance électrique (152) et une deuxième impédance électrique (154), le deuxième circuit électrique étant susceptible d'être fermé lors d'un contact simultané de l'utilisateur avec la première et la deuxième électrode de contact manuel (132, 134),
   - au moins un dispositif de mesure (156, 158) d'une caractéristique d'impédance du premier circuit électrique et d'une caractéristique d'impédance du deuxième circuit électrique,
   - un comparateur (174) de la caractéristique d'impédance du premier circuit électrique (142) et d'au moins une caractéristique de seuil fonction de la caractéristique d'impédance du deuxième circuit électrique (144), le comparateur étant relié au dispositif d'arrêt d'urgence, pour provoquer un arrêt d'urgence (120, 126, 127) en cas de franchissement de la caractéristique de seuil.

12. Outil selon la revendication 11, dans lequel le deuxième circuit électrique (144) comprend un interrupteur (170) , l'interrupteur étant piloté par l'interface de commande de fonctionnement (128) pour ouvrir le deuxième circuit (144) lorsque l'organe de commande (130) est en position de fonctionnement, et pour fermer le deuxième circuit lorsque l'organe de commande (130) est en position de repos, le dispositif de mesure (156, 158) étant configuré pour mesurer une caractéristique d'impédance du premier circuit électrique (142) lorsque le deuxième circuit électrique (144) est ouvert et pour mesurer une caractéristique d'impédance du deuxième circuit électrique (144) lorsque le deuxième circuit électrique (144) est fermé.

13. Outil selon la revendication 10 dans lequel le dispositif de surveillance comporte :

   - un circuit électrique de surveillance (143) comprenant la première électrode de contact manuel (132) et l'organe actif (112), le circuit électrique de surveillance étant susceptible d'être fermé, lors d'un contact simultané de l'utilisateur avec ladite première électrode de contact manuel (132) et avec l'organe actif (112),
   - un générateur électrique (156) d'un courant de surveillance dans le premier circuit électrique,
   - un dispositif de mesure (145) d'une tension de surveillance entre l'organe actif (112) et la deuxième électrode de contact manuel (134),
   - un comparateur (175) d'au moins une caractéristique électrique de surveillance fonction de la tension de surveillance et d'une caractéristique électrique de seuil fonction d'une valeur d'impédance majorant une valeur d'impédance de conduction du corps humain, le comparateur (175) étant relié au dispositif d'arrêt d'urgence (120, 126, 127) pour provoquer un arrêt d'urgence lorsque la caractéristique électrique de surveillance franchit la caractéristique électrique de seuil.

14. Outil selon la revendication 13, dans lequel la caractéristique électrique de surveillance est une tension fonction de la tension de surveillance et dans lequel la caractéristique électrique de seuil est une tension de seuil fonction de la valeur d'impédance majorant une valeur d'impédance de conduction du corps humain et du courant de surveillance.

15. Outil selon l'une quelconque des revendications 12 à 14, dans lequel la caractéristique électrique de surveillance est l'une parmi :

   - une tension égale à la tension de surveillance, ou fonction de la tension de surveillance, la caractéristique électrique de seuil étant égale au produit de la valeur d'impédance majorant une valeur d'Impédance de conduction du corps humain et du courant de surveillance,
   - une valeur d'impédance fonction de la tension de surveillance et du courant de surveillance, la caractéristique de seuil étant une valeur d'impédance fonction de la valeur d'impédance majorant une valeur d'impédance de conduction du corps humain,
   - un rapport de la tension de surveillance sur le courant de surveillance, la caractéristique de seuil étant égale à la valeur d'impédance majorant une valeur d'impédance de conduction du corps humain.

**Patentansprüche**

1. Steuervorrichtung für ein motorisiertes Werkzeug, umfassend:

    - eine Schnittstelle zur Betriebssteuerung (128), die mit einem Steuerorgan (130) mit Handbetätigung versehen ist, das einen Handauflagebereich (22) aufweist, für eine Verschiebung des Steuerorgans zwischen einer Ruheposition und wenigstens einer Betriebsposition, **gekennzeichnet durch**
    - eine impedanzmetrische Sicherheitsschnittstelle (131), umfassend eine erste Handkontaktelektrode (132) und eine zweite Handkontaktelektrode (134), die elektrisch voneinander isoliert sind,

    und wobei die Handkontaktelektroden (132, 134) auf dem Steuerorgan (130) eingerichtet sind und sich auf dem Handauflagebereich (22) des Steuerorgans erstrecken.

2. Vorrichtung nach Anspruch 1, wobei das Steuerorgan (130) wenigstens eines von einem ersten vertieften Relief (40) und einem elektrischen, isolierenden Trennelement (31) aufweist, das ein Material umfasst, das ausgewählt wird aus einem feuchtigkeitsabsorbierenden Material und einem hydrophoben Material, wobei sich das erste vertiefte Relief (40) beziehungsweise das Trennelement (31) auf dem Handauflagebereich (22) zwischen der ersten Handkontaktelektrode (132) und der zweiten Handkontaktelektrode (134) erstrecken.

3. Vorrichtung nach Anspruch 2, wobei das erste vertiefte Relief (40) ein Relief mit eckigen Kanten ist.

4. Vorrichtung nach einem der Ansprüche 2 oder 3, wobei das Steuerorgan (130) eine längliche Form aufweist und wobei sich die erste und die zweite Handkontaktelektrode (132, 134) und das erste vertiefte Relief (40) längs auf dem Steuerorgan (130) erstrecken.

5. Vorrichtung nach einem der Ansprüche 2 bis 4, wobei das Steuerorgan (130) eines von einem Auslösehebel (18) und einem Druckknopf (19) umfasst.

6. Vorrichtung nach einem der Ansprüche 2 bis 5, wobei das Steuerorgan (130) einen Hebel (18) umfasst, wobei sich das erste vertiefte Relief (40) auf einer ersten Fläche (52) des Hebels erstreckt, die den Handauflagebereich (22) bildet.

7. Vorrichtung nach Anspruch 6, wobei der Hebel (18) wenigstens ein zweites vertieftes Relief (42) umfasst, das sich auf einer zweiten Fläche (54) des Hebels erstreckt, die der ersten Fläche (52) des Hebels gegenüberliegt.

8. Vorrichtung nach einem der Ansprüche 2 bis 5, wobei das Steuerorgan einen Mittelkörper (30, 31) aus einem elektrischen, isolierenden Material und Beläge aus einem elektrischen, leitenden Material umfasst, die auf seitlichen Flanken des Mittelkörpers angestückt sind, wobei die Beläge jeweils die erste Handkontaktelektrode (132) und die zweite Handkontaktelektrode (134) der impedanzmetrischen Schnittstelle (131) bilden.

9. Vorrichtung nach einem der Ansprüche 1 bis 8, wobei die impedanzmetrische Schnittstelle (131) weiter wenigstens einen elektrischen, leitenden Handschuh (133) umfasst, der von einem Benutzer der Steuervorrichtung getragen wird.

10. Gesichertes, motorisiertes Werkzeug (12), umfassend:

    - ein elektrisches, leitendes, aktives Organ (112),
    - eine Steuervorrichtung (10),
    - einen Motor (120) zum Antrieb des aktiven Organs,
    - eine Überwachungsvorrichtung (131, 142, 143, 144, 174, 175) mit einem Komparator von elektrischen Charakteristika, die auf einen Kontakt eines Benutzers mit dem aktiven Organ (112) reagiert,
    - eine Nothaltvorrichtung des aktiven Organs (120, 126, 127), die von der Überwachungsvorrichtung gesteuert wird,

    **dadurch gekennzeichnet, dass**:

    - die Steuervorrichtung (10) einem der Ansprüche 1 bis 9 entspricht,
    - der Motor zum Antrieb des aktiven Organs mittels der Schnittstelle zur Betriebssteuerung (128) der Steuervorrichtung (10) gesteuert wird und
    - die Überwachungsvorrichtung die impedanzmetrische Sicherheitsschnittstelle (131) der Steuervorrichtung (10) umfasst.

11. Werkzeug nach Anspruch 10, wobei die Überwachungsvorrichtung umfasst:

    - einen ersten elektrischen Kreis (142), der die erste Handkontaktelektrode (132), eine erste elektrische Impedanz (152) und das aktive Organ (112) umfasst, wobei der erste elektrische Kreis (142) imstande ist, bei einem gleichzeitigen Kontakt des Benutzers mit der ersten Handkontaktelektrode (132) und dem aktiven Organ (112) geschlossen zu werden,

- einen zweiten elektrischen Kreis (144), der die erste und die zweite Handkontaktelektrode (132, 134), die erste elektrische Impedanz (152) und eine zweite elektrische Impedanz (154) umfasst, wobei der zweite elektrische Kreis imstande ist, bei einem gleichzeitigen Kontakt des Benutzers mit der ersten und der zweiten Handkontaktelektrode (132, 134) geschlossen zu werden,

- wenigstens eine Vorrichtung zur Messung (156, 158) eines Impedanzcharakteristikums des ersten elektrischen Kreises und eines Impedanzcharakteristikums des zweiten elektrischen Kreises,

- einen Komparator (174) des Impedanzcharakteristikums des ersten elektrischen Kreises (142) und wenigstens eines Grenzcharakteristikums, das abhängig ist von dem Impedanzcharakteristikum des zweiten elektrischen Kreises (144), wobei der Komparator mit der Nothaltvorrichtung verbunden ist, um einen Nothalt (120, 126, 127) im Fall einer Übertretung des Grenzcharakteristikums hervorzurufen.

12. Werkzeug nach Anspruch 11, wobei der zweite elektrische Kreis (144) einen Schalter (170) umfasst, wobei der Schalter von der Schnittstelle zur Betriebssteuerung (128) gesteuert wird, um den zweiten Kreis (144) zu öffnen, wenn sich das Steuerorgan (130) in Betriebsposition befindet, und um den zweiten Kreis zu schließen, wenn sich das Steuerorgan (130) in Ruheposition befindet, wobei die Vorrichtung zur Messung (156, 158) ausgestaltet ist, ein Impedanzcharakteristikum des ersten elektrischen Kreises (142) zu messen, wenn der zweite elektrische Kreis (144) offen ist, und ein Impedanzcharakteristikum des zweiten elektrischen Kreises (144) zu messen, wenn der zweite elektrische Kreis (144) geschlossen ist.

13. Werkzeug nach Anspruch 10, wobei die Überwachungsvorrichtung umfasst:

- einen elektrischen Überwachungskreis (143), der die erste Handkontaktelektrode (132) und das aktive Organ (112) umfasst, wobei der elektrische Überwachungskreis imstande ist, bei einem gleichzeitigen Kontakt des Benutzers mit der ersten Handkontaktelektrode (132) und mit dem aktiven Organ (112) geschlossen zu werden,

- einen elektrischen Generator (156) eines Überwachungsstroms in dem ersten elektrischen Kreis,

- eine Vorrichtung zur Messung (145) einer Überwachungsspannung zwischen dem aktiven Organ (112) und der zweiten Handkontaktelektrode (134),

- einen Komparator (175) wenigstens eines elektrischen Überwachungscharakteristikums, das abhängig ist von der Überwachungsspannung, und eines elektrischen Grenzcharakteristikums, das abhängig ist von einem Impedanzwert, der einen Leitungsimpedanzwert des menschlichen Körpers erhöht, wobei der Komparator (175) mit der Nothaltvorrichtung (120, 126, 127) verbunden ist, um einen Nothalt hervorzurufen, wenn das elektrische Überwachungscharakteristikum das elektrische Grenzcharakteristikum übersteigt.

14. Werkzeug nach Anspruch 13, wobei das elektrische Überwachungscharakteristikum eine Spannung ist, die abhängig ist von der Überwachungsspannung, und wobei das elektrische Grenzcharakteristikum eine Grenzspannung ist, die abhängig ist von dem Impedanzwert, der einen Leitungsimpedanzwert des menschlichen Körpers erhöht, und dem Überwachungsstrom.

15. Werkzeug nach einem der Ansprüche 12 bis 14, wobei das elektrische Überwachungscharakteristikum eines ist von:

- einer Spannung gleich der Überwachungsspannung oder abhängig von der Überwachungsspannung, wobei das elektrische Grenzcharakteristikum gleich ist dem Produkt des Impedanzwerts, der einen Leitungsimpedanzwert des menschlichen Körpers erhöht, und des Überwachungsstroms,

- einem Impedanzwert, der abhängig ist von der Überwachungsspannung und dem Überwachungsstrom, wobei das Grenzcharakteristikum ein Impedanzwert ist, der abhängig ist von dem Impedanzwert, der einen Leitungsimpedanzwert des menschlichen Körpers erhöht,

- einem Bezug der Überwachungsspannung auf den Überwachungsstrom, wobei das Grenzcharakteristikum gleich ist dem Impedanzwert, der einen Leitungsimpedanzwert des menschlichen Körpers erhöht.

**Claims**

1. Control device for a motorised tool, comprising:

- an interface (128) for controlling operation, provided with a control member (130) with manual actuation, having a manual bearing surface (22), for a movement of the control member between a rest position and at least one operating position, **characterised by**:

- a security impedancemetric interface (131), comprising a first electrode for manual contact (132) and a second electrode for manual contact (134), electrically insulated from one another,

and wherein the electrodes for manual contact (132, 134) are created on the control member (130) and extend over the manual bearing surface (22) of the control member.

2. Device according to claim 1, wherein the control member (130) has at least one out of a first hollow relief (40), and an electrically insulating separator (31) comprising a material chosen from a material that absorbs humidity and a hydrophobic material, the first hollow relief (40), and respectively the separator (31), extending over the manual bearing surface (22), between the first electrode for manual contact (132) and the second electrode for manual contact (134).

3. Device according to claim 2, wherein the first hollow relief (40) is a relief with angular edges.

4. Device according to any one of claims 2 or 3, wherein the control member (130) has an elongated shape and wherein the first and the second electrode (132, 134) for manual contact, and said first hollow relief (40), extend longitudinally on the control member (130).

5. Device according to any one of claims 2 to 4, wherein the control member (130) comprises one out of a trigger with a lever (18) and a push button (19).

6. Device according to any one of claims 2 to 5, wherein the control member (130) comprises a lever (18), wherein the first hollow relief (40) extends on a first face (52) of the lever forming the manual bearing surface (22).

7. Device according to claim 6, wherein the lever (18) comprises at least one second hollow relief (42) extending on a second face (54) of the lever, opposite to the first face (52) of the lever.

8. Device according to any one of claims 2 to 5, wherein the control member comprises a central body (30, 31) made of an electrically insulating material and liners made of an electrically conductive material added onto the lateral sides of the central body, the liners respectively forming the first electrode for manual contact (132) and the second electrode for manual contact (134) of the impedancemetric interface (131) .

9. Device according to any one of claims 1 to 8, wherein the impedancemetric interface (131) further comprises at least one electrically conductive glove (133) carried by a user of the control device.

10. Secure motorised tool (12) comprising:

- an electrically conductive active member (112),
- a control device (10),
- a motor (120) for driving the active member,
- a monitoring device (131, 142, 143, 144, 174, 175) with a comparator of electric characteristics, sensitive to a contact of a user with the active member (112),
- a device for emergency stoppage of the active member (120, 126, 127), controlled by the monitoring device,

**characterised in that**:

- the control device (10) is according to any one of claims 1 to 9,
- the motor for driving the active member is controlled via the interface for controlling operation (128) of the control device (10) and
- the monitoring device comprises the security impedancemetric interface (131) of the control device (10) .

11. Tool according to claim 10, wherein the monitoring device includes:

- a first electric circuit (142) comprising the first electrode for manual contact (132), a first electric impedance (152) and the active member (112), the first electric circuit (142) being capable of being closed, during a simultaneous contact of the user with said first electrode for manual contact (132) and the active member (112),
- a second electric circuit (144) comprising the first and the second electrode for manual contact (132, 134), the first electric impedance (152) and a second electric impedance (154), the second electric circuit being capable of being closed during a simultaneous contact of the user with the first and the second electrode for manual contact (132, 134),
- at least one device (156, 158) for measuring an impedance characteristic of the first electric circuit and an impedance characteristic of the second electric circuit,
- a comparator (174) of the impedance characteristic of the first electric circuit (142) and of at least one threshold characteristic that is a function of the impedance characteristic of the second electric circuit (144), the comparator being connected to the emergency stoppage device to trigger an emergency stoppage (120, 126, 127) in case the threshold characteristic is exceeded.

**12.** Tool according to claim 11, wherein the second electric circuit (144) comprises a switch (170), the switch being controlled by the interface for controlling operation (128) to open the second circuit (144) when the control member (130) is in an operating position, and to close the second circuit when the control member (130) is in a rest position, the measurement device (156, 158) being configured to measure an impedance characteristic of the first electric circuit (142) when the second electric circuit (144) is open and to measure an impedance characteristic of the second electric circuit (144) when the second electric circuit (144) is closed.

**13.** Tool according to claim 10, wherein the monitoring device includes:

- a monitoring electric circuit (143) comprising the first electrode for manual contact (132) and the active member (112), the electric monitoring circuit being capable of being closed during a simultaneous contact of the user with said first electric for manual contact (132) and with the active member (112),
- an electric generator (156) of a monitoring current in the first electric circuit,
- a device (145) for measuring a monitoring voltage between the active member (112) and the second electrode (134) for manual contact,
- a comparator (175) of at least one monitoring electric characteristic that is a function of the monitoring voltage and of a threshold electric characteristic that is a function of an impedance value increasing an impedance value of conduction of the human body, the comparator (175) being connected to the emergency stoppage device (120, 126, 127) to trigger an emergency stoppage when the monitoring electric characteristic exceeds the threshold electric characteristic.

**14.** Tool according to claim 13, wherein the monitoring electric characteristic is a voltage that is a function of the monitoring voltage and wherein the threshold electric characteristic is a threshold voltage that is a function of the impedance value increasing an impedance value of conduction of the human body and of the monitoring current.

**15.** Tool according to any one of claims 12 to 14, wherein the monitoring electric characteristic is one out of:

- a voltage equal to the monitoring voltage, or that is a function of the monitoring voltage, the threshold electric characteristic being equal to the product of the impedance value increasing an impedance value of conduction of the human body and of the monitoring current,
- an impedance value that is a function of the monitoring voltage and of the monitoring current, the threshold characteristic being an impedance value that is a function of the impedance value increasing an impedance value of conduction of the human body,
- a ratio of the monitoring voltage to the monitoring current, the threshold characteristic being equal to the impedance value increasing an impedance value of conduction of the human body.

FIG. 1

FIG. 2

FIG. 3

FIG. 4

FIG. 5A

FIG. 5B

FIG. 5C

FIG. 6A

FIG. 6B

FIG. 6C

FIG. 7

29

FIG. 8

**EP 3 714 198 B1**

RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2712837
- FR 2779669
- FR 2831476
- FR 2838998
- FR 2846729
- FR 2963081
- FR 3001404
- EP 2490865 A
- EP 2825811 A
- US 5025175 A
- US 7365955 B
- WO 2012025456 A
- FR 1771254
- FR 1771255